(19) Europäisches Patentamt
European Patent Office
Office européen des brevets

(11) Publication number: **0 417 997 B1**

(12) **EUROPEAN PATENT SPECIFICATION**

(45) Date of publication of patent specification: **22.11.95**

(51) Int. Cl.$^6$: **C23C 16/42**, H01L 21/285

(21) Application number: **90309832.5**

(22) Date of filing: **07.09.90**

# (54) Process for forming metal deposited film containing aluminum as main component by use of alkyl aluminum hydride.

(30) Priority: **09.09.89 JP 233925/89**
**09.09.89 JP 233927/89**

(43) Date of publication of application:
**20.03.91 Bulletin 91/12**

(45) Publication of the grant of the patent:
**22.11.95 Bulletin 95/47**

(84) Designated Contracting States:
**AT BE CH DE DK ES FR GB GR IT LI LU NL SE**

(56) References cited:

**JAPANESE JOURNAL OF APPLIED PHYSICS/PART 2: LETTERS, vol. 27, no. 8, August 1988, Tokyo (JP); M. HANABUSA et al., pp. L1392-L1394**

**PATENT ABSTRACTS OF JAPAN, vol. 10, no. 71 (C-334)[2128], 20 March 1986**

**JAPANESE JOURNAL OF APPLIED PHYSICS, vol. 27, no. 11, November 1988, Tokyo (JP); A. SEKIGUCHI et al., pp. L2134-L2136**

(73) Proprietor: **CANON KABUSHIKI KAISHA**
**30-2, 3-chome, Shimomaruko,**
**Ohta-ku**
**Tokyo (JP)**

(72) Inventor: **Mikoshiba, Nobuo**
**30-18 Yagiyamahon-cho,**
**2-chome**
**Taihaku-ku,**
**Sendai-shi,**
**Miyagi-ken (JP)**
Inventor: **Tsubouchi, Kazuo**
**30-38, Hitokita 2-chome**
**Taihaku-ku,**
**Sendai-shi,**
**Miyagi-ken (JP)**
Inventor: **Masu, Kazuya**
**3-1-106, Mikamine 1-chome**
**Taihaku-ku,**
**Sendai-shi,**
**Miyagi-ken (JP)**

(74) Representative: **Beresford, Keith Denis Lewis et al**
**BERESFORD & Co.**
**2-5 Warwick Court**
**High Holborn**
**London WC1R 5DJ (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

## Description

### BACKGROUND OF THE INVENTION

### Field of the invention

This invention relates to a process for forming a deposited film, particularly a process for forming an Al-Si deposited film which can be preferably applied to electrodes or wiring of a semiconductor integrated circuit device, etc.

### Related background art

In the prior art, in electronic devices or integrated circuits by use of semiconductors, for electrodes and wiring, aluminum (Al) or a metal containing aluminum as main component such as Al-Si and the like has been primarily used. Al has many advantages such that it is inexpensive and high in electroconductivity, that it can be also internally chemically protected because a dense oxidized film can be formed on the surface, and that it has good adhesion to Si, etc.

As the method for forming a film for electrodes and wiring of Al or Al-Si as mentioned above, there has been used in the prior art the sputtering method such as magnetron sputtering, etc.

However, selective deposition and selective growth can not be realized by the sputtering method which has been, used in the prior art. The sputtering is the physical deposition method based on flying of sputtered particles in vacuum, the film thickness at the stepped portion or the insulating film side wall becomes extremely thin, leading to wire breaking in an extreme case. Nonuniformity of film thickness or wire breaking has the drawback that reliability of LSI is markedly lowered.

On the other hand, since the integration degree of the integrated circuit such as LSI, etc. is increased, and fine formation of wiring or multi-layer wiring has been particularly required in recent years, there is an increasing severe demand not found up to date for Al or Al-Si wiring of the prior art. With finer dimensional formation by increased integration degree, the surface of LSI, etc. is subject to excessive unevenness due to oxidation, diffusion, thin film deposition, and etching, etc. For example, electrodes or wiring metal must be deposited on the surface with a stepped difference, or deposited in a via-hole which is fine in diameter and deep. In 4 Mbit or 16 Mbit DRAM (dynamic RAM), etc., the aspect ratio (via-hole depth/via-hole diameter) of via-hole in which a metal composed mainly of Al such as Al-Si, etc. is to be deposited is 1.0 or more, and the via-hole diameter itself also becomes 1 $\mu$m or less. Therefore, even for a via-hole with large aspect ratio, the technique which can deposit an Al-Si compound is required.

Particularly, for performing sure electrical connection to the device under insulating film such as $SiO_2$, etc., rather than film formation, Al-Si is required to be deposited so as to embed only the via-hole of the device. In such case, a method of depositing an Al alloy only on Si or metal surface and not depositing it on an insulating film such as $SiO_2$, etc. is required.

As the improved sputtering method, there has been developed the bias sputtering method in which a bias is applied on a substrate and deposition is performed so as to embed Al or an Al-Si compound only in the via-hole by utilizing the sputter etching action and the deposition action on the substrate surface. However, since the bias voltage of some 100 V or higher is applied on the substrate, deleterious influence on the device occurs because of charged particle damaging such as change in threshold of MOSFET, etc. Also, because of presence of both etching action and deposition action, there is the problem that the deposition speed cannot be essentially improved.

In order to solve the problems as described above, various types of CVD (Chemical Vapor Deposition) methods have been proposed. In these methods, chemical reaction of the starting gas in some form is utilized. In plasma CVD or optical CVD, decomposition of the starting gas occurs in gas phase, and the active species formed there further reacts on the substrate to give rise to film formation. In these CVD methods, surface coverage on unevenness on the substrate surface is good. However, carbon atoms contained in the starting gas molecule are incorporated into the film. Also, particularly in plasma CVD, the problem remained that there was damage by charged particles (so called plasma damage) as in the case of the sputtering method.

The thermal CVD method, in which the film grows through the surface reaction primarily on the substrate surface, is good in surface coverage on unevenness such as stepped portion of the surface, etc. Also, it can be expected that deposition within via-hole will readily occur. Further, wire breaking at the stepped portion can be avoided. Furthermore, there are not caused damages by charged particles which have been observed in the case of the plasma CVD or the sputtering method. The methods of such a kind

include, for example, the method seen in Journal of Electrochemical Society, Vol. 131, p. 2175 (1984). In this method triisobutyl aluminum $(i\text{-}C_4H_9)_3Al$ (TIBA) is used as organic aluminum gas and an Al film is formed at a film formation temperature of 260 °C and a reaction tube pressure of 66.5 Pa (0.5 Torr). The substrate temperature is then maintained at about 450 °C and $SiH_4$ is introduced to diffuse Si in the Al film, thus obtaining an Al-Si film.

When TIBA is to be used, a continuous film can not be obtained unless pretreatment is effected in which prior to film formation, $TiCl_4$ is flowed to activate the substrate surface to form nuclei. Furthermore, in case where TIBA is used, there is a problem that surface flatness is not sufficient even when $TiCl_4$ is used. By this method it is not possible to effect selective growth such as Al-Si deposition only in via-holes.

As another method, there can be mentioned the method described in Japanese Journal of Applied Physics, Vol. 27, No. 11, p. L2134 (1988). In this method, TIBA and $Si_2H_6$ diluted with Ar gas are supplied, and the gases are heated before TIBA reaches the substrate. By this method, an Al-Si film of a low resistivity can be epitaxially grown on a Si(100) wafer. Although the film obtained by this method has good high quality, there are involved the problems that control is difficult due to necessity of heating the gases and that apparatus for effecting this method is complicated.

Japanese Laid-Open Patent Application No. 63-33569 describes a method of forming a film by using no $TiCl_4$, but using in place thereof organic aluminum and heating it in the vicinity of the substrate. According to this method, Al can be deposited selectively only on the metal or semiconductor surface from which the naturally oxidized film has been removed.

In this case, it is clearly stated that the step of removing the naturally oxidized film on the substrate surface is necessary before introduction of TIBA. Also, it is described that, since TIBA can be used alone, no carrier gas is required to be used, but Ar gas may be also used as the carrier gas. However, the reaction of TIBA with another gas (e.g. $H_2$) is not contemplated at all, and there is no description of use of $H_2$ as the carrier gas. Also, in addition to TIBA, trimethyl aluminum (TMA) and triethyl aluminum (TEA) are mentioned, but there is no specific description of other organic metals. This is because, since the chemical properties of organic metals generally vary greatly if the organic substituent attached to the metal element varies little, it is necessary to investigate individually by detailed experimentation to determine what organic metal should be used.

In the CVD method as described above, not only there is an inconvenience that the naturally oxidized film must be removed, but also there is the drawback that no surface smoothness can be obtained. Also, there is the restriction that heating of the gas is necessary, and yet heating must be done in the vicinity of the substrate. Besides, it must also be experimentally determined at what proximity to the substrate heating must be done, whereby there is also the problem that the place for setting the heater cannot be necessarily freely chosen.

In the pre-text of the 2nd Symposium of Electrochemical Society, Branch of Japan (July 7, 1989), on page 75, there is a description of film formation of Al according to the double wall CVD method. In this method, TIBA is used and the device is designed so that the gas temperature of TBA can be made higher than the substrate temperature. This method may be also regarded as a modification of the above-mentioned Japanese Laid-open Patent Application No. 63-33569. Also in this method, Al can be selectively grown only on a metal or semiconductor, but not only the difference between the gas temperature and the substrate surface temperature can be controlled with difficulty, but also there is the drawback that the bomb and the pipeline must be heated. Moreover, according to this method, there are involved such problems that no uniform continuous film can be formed, that flatness of the film is poor, etc., unless the film is made thick to some extent.

As set forth above, the prior art methods have the problems to be solved that it is difficult to obtain a flat Al-Si film of a low resistivity and good quality, that there is considerable limitation in apparatus and in film formation.

As described above, prior art methods cannot necessarily effect well selective growth of Al-Si, and even if possible, there is a problem with respect to flatness, resistance, purity, etc. of the Al film formed Also, there has been involved the problem that the film formation method is complicated and can be controlled with difficulty.

## SUMMARY OF THE INVENTION

The invention provides a thermal CVD process for forming a deposited Al-Si film as set out in claim 1 below.

Embodiments of the above process enables a deposited film of Al-Si to be formed which is of good quality when used as an electroconductive material and which enables the film to be formed with good

controllability at a desired location. The film forming devices used to carry out the method need not be complex or expensive, and the resulting Al-Si film has extremely broad general purpose utility and yet is of good quality.

Embodiments of the process can give an Al-Si film of excellent surface characteristics, electrical characteristics, purity, etc.

How the invention can be carried out will be described with reference to the accompanying drawings.

## BRIEF DESCRIPTION OF THE DRAWINGS

Fig. 1 is a schematic view for illustration of a suitable disposed film forming device in practicing the deposited film forming process according to the process of the present invention.

Fig. 2 is a schematic view for illustration of another suitable deposited film forming device in practicing the deposited film forming process according to the present invention.

Figs. 3A-3E are schematic sectional views for illustration of the deposited film forming process according to one embodiment of the present invention.

Figs. 4A-4D are illustrations for explaining the mechanism of A1 deposition according to the present invention.

## DETAILED DESCRIPTION OF THE PREFERRED EMBODIMENTS

Preferred embodiments according to the present invention are described in detail below, but the present invention is not limited by these embodiments, and it may have a constitution which accomplishes the object of the present invention.

One preferred embodiment of the present invention is a process for forming a deposited film comprising the steps of:

(a) providing a substrate having an electron donative surface (A) in a space for formation of the deposited film;

(b) introducing a gas of an alkyl aluminum hydride, a gas containing silicon atoms and hydrogen gas into the space for formation of the deposited film; and

(c) maintaining the temperature of the electron donative surface (A) within the range of from the decomposition temperature of the alkyl aluminum hydride to 450 °C to form an aluminum film containing silicon on the electron donative surface (A).

Further, another preferred embodiment of the present invention is a process for forming a deposited film comprising the steps of:

(a) providing a substrate having an electron donative surface (A) and a electron non-donative surface (B) in a space for formation of the deposited film;

(b) introducing a gas of an alkyl aluminum hydride, a gas containing silicon atoms and hydrogen gas into the space for formation of the deposited film; and

(c) maintaining the temperature of the electron donative surface (A) within the range of from the decomposition temperature of the alkyl aluminum hydride to 450 °C to form an aluminum film containing silicon selectively on the electron donative surface (A).

In the following, prior to detailed description, first, the process for forming a deposited film by use of an organic metal is outlined.

The decomposition reaction of an organic metal, and hence the thin film deposition reaction will vary greatly depending on the kind of the metal atom, the kind of the alkyl bonded to the metal atom, the means of causing the decomposition reaction to occur, the atmospheric gas, etc.

For example, in the case of M-$R_3$ (M: the group III metal, R: alkyl group), trimethyl gallium:

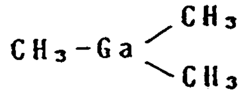

in thermal decomposition undergoes radical cleavage wherein Ga-$CH_3$ bond is cleaved, while triethyl gallium:

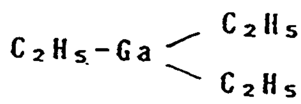

in thermal decomposition is decomposed through $\beta$-elimination into:

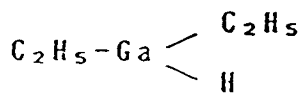

and $C_2H_4$. On the other hand, triethyl aluminum attached with the same ethyl group:

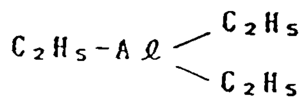

in thermal decomposition undergoes radical decomposition in which Al-$C_2H_5$ is cleaved. However, tri-iso-butyl aluminum having $iC_4H_9$ bonded therein:

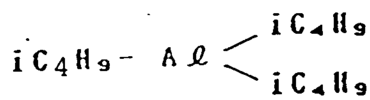

is subject to $\beta$-elimination.

Trimethyl aluminum (TMA) comprising $CH_3$ groups and Al has a dimer structure at room temperature:

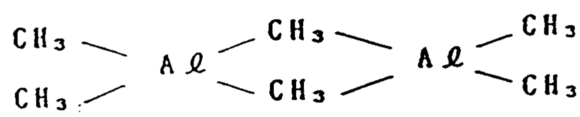

and thermal decomposition is radical decomposition in which Al-$CH_3$ group is cleaved, and at a temperature of 150 °C or lower, it reacts with atmospheric $H_2$ to form $CH_4$, and forms finally Al.

However, at a high temperature of 300 °C or higher, even if $H_2$ may be present in the atmosphere, $CH_3$ group will withdraw H from the TMA molecule, until finally Al-C compound is formed.

Also, in the case of TMA, in light or a certain region controlled in electric power in $H_2$ atmosphere high frequency (ca. 13.56 MHz) plasma, $C_2H_6$ will be formed by the bridging $CH_3$ between two Al's.

In essence, since even an organic metal comprising $CH_3$ group which the simplest alkyl group, $C_2H_5$ group or $iC_4H_9$ group and Al or Ga has a reaction mode depending on the kind of the alkyl group, the kind of the metal atom, the excitation decomposition means, for deposition of a metal atom from an organic metal on a desired substrate, the decomposition reaction must be strictly controlled. For example, when Al is to be deposited from triisobutyl aluminum:

(TIBA: 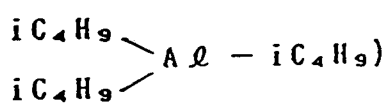

in the low pressure CVD method comprising mainly thermal reaction, unevenness of $\mu$m order is formed on the surface, whereby the surface morphology is inferior. Also, hillock generation by heat treatment, Si surface roughening through Si diffusion at the interface between Al and Si occur, and also migration resistance is inferior, whereby it can be utilized for ultra-LSI process with difficulty.

For this reason, a method for controlling precisely both the gas temperature and the substrate temperature has been attempted. However, the device is complicated, and the method is of the sheet treatment type in which deposition can be effected only on one wafer by one deposition process. Besides, since the deposition speed is 500 A/min. at the highest, the throughput necessary for bulk production cannot be realized.

Similarly, when TMA is employed, Al deposition has been attempted by use of plasma or light, the device also becomes complicated due to use of plasma or light, and also because of the sheet type device, there remains room for improvement for sufficient improvement of throughput.

Dimethyl aluminum hydride (DMAH) as the alkyl aluminum hydride to be utilized in the present invention is a substance known as alkyl metal, but it could not be estimated at all what Al thin film could be deposited depending on what reaction mode, unless deposited films are formed under all the conditions. For example, in an example of deposition Al by optical CVD from DMAH, the surface morphology is inferior, and the resistivity value was greater than the bulk value (2.7 μohm•cm) as several μohm to 10 μohm cm, thus being inferior in film quality.

Now, referring to the drawings, preferred embodiments of the present invention are described in more detail.

In the present invention, for depositing an Al-Si film of good quality as the electroconductive deposition film on a substrate, the CVD method is used.

More specifically, by use of dimethyl aluminum hydride (DMAH):

Chemical formula: 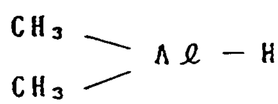

or monomethyl aluminum hydride ($MMAH_2$):

Chemical formula: 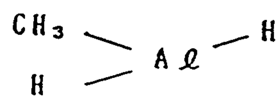

as alkyl aluminum hydride which is an organic metal as the starting gas containing at least one atom which becomes the constituent of the deposited film, a gas containing Si atoms as the starting gas and $H_2$ as the reaction gas, an Al-Si film is formed by gas phase growth with a gas mixture of these on a substrate.

As the substrate applicable in the present invention, a material having electron donative property may be employed.

The electron donative material is described in detail below.

The electron donative material refers to one having free electrons existing or free electrons intentionally formed in the substrate, for example, a material having a surface on which the chemical reaction is promoted through give-and-take of electrons with the starting gas molecules attached on the substrate surface. For example, generally metals and semiconductors correspond to such material. Those having very thin oxidized film on the metal or semiconductor surface are also included. For, with such thin film, the chemical reaction can occur between the substrate and the attached starting molecules.

Specifically, there may be included semiconductors such as single crystalline silicon, polycrystalline silicon, amorphous silicon, etc., binary system or ternary system or quaternary system III-V compound semiconductors comprising combinations of Ga, In, Al as the group III element and P, As, N as the group V element, or II-IV compound semiconducters, or metals themselves such as tungsten, molybdenum, tantalum, aluminum, titanium, copper, etc., or silicides of the above metals such as tungsten silicide, molybdenum silicide, tantalum silicide, aluminum silicide, titanium silicide, etc., further metals containing either one of the constituent of the above metals such as aluminum silicon, aluminum titanium, aluminum copper, aluminum tantalum, aluminum silicon copper, aluminum silicon titanium, aluminum palladium, titanium nitride, etc.

On the substrate with such constitution, Al is deposited only through simple thermal reaction in the reaction system of the starting gas and $H_2$. For example, the thermal reaction in the reaction system between DMAH and $H_2$ may be basically considered as follows:

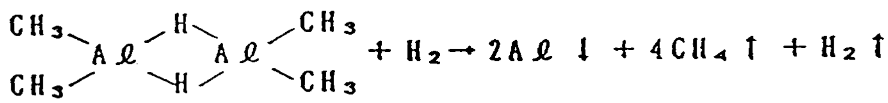

DMAH assumes a dimer structure at room temperature. Also, with $MMAH_2$, a high quality Al film could be formed by thermal reaction as shown below in Examples.

Since $MMAH_2$ has low vapor pressure as 0.01 to 0.1 Torr at room temperature, a large amount of the starting material can be transported with difficulty, and the upper limit value of the deposition speed is several hundred Å/min. in the present embodiment, and preferably, it is most desirable to use DMAH of which vapor pressure is 1 Torr at room temperature.

In another embodiment of the present invention, the CVD method is used for selective deposition of a good Al film as the electroconductive deposition film on the substrate.

More specifically, as described above, by use of dimethyl aluminum hydride (DMAH) or monomethyl aluminum hydride ($MMAH_2$), a gas containing Si atoms as the starting gas and $H_2$ as the reaction gas, an Al-Si film is selectively formed on the substrate by gas phase growth with a gas mixture of these.

The substrate applicable in the present invention has a first substrate surface material for formation of the surface on which Al-Si is deposited, and a second substrate surface material on which no Al-Si is deposited. And, as the first substrate surface material, a material having the electron donative surface is used.

In contrast, as the material for forming the surface on which Al-Si is not deposited selectively, namely the material for forming the electron non-donative surface, conventional insulating materials, oxidized silicon formed by thermal oxidation, CVD, etc., glass or oxidized film such as BSG, PSG, BPSG, etc., thermally nitrided film, silicon nitrided film by plasma CVD, low pressure CVD, ECR-CVD method, etc.

Fig. 1 is a schematic view showing a preferable deposition film forming device for applying the present invention.

Here, 1 is a substrate for forming an Al-Si film. The substrate 1 is mounted on a substrate holder 3 provided internally of the reaction tube 2 for forming a space for formation of a deposited film which is substantially closed to Fig. 1. As the material constituting the reaction tube 2, quartz is preferable, but it may be also made of a metal. In this case, it is preferable to cool the reaction tube. The substrate holder 3 is made of a metal, and is provided with a heater 4 so that the substrate mounted thereon can be heated. And, the constitution is made so that the substrate temperature can be controlled by controlling the heat generation temperature of the heater 4.

The feeding system of gases is constituted as described below.

5 is a gas mixer, in which the first starting gas, the second starting gas and the reaction gas are mixed, and the mixture is fed into the reaciton tube 2. 6 is a starting gas gasifier provided for gasification of an organic metal as the first starting gas.

The organic metal to be used in the present invention is liquid at room temperature, and is formed into saturated vapor by passing a carrier gas through the liquid of the organic metal within the gasifier 6, which is in turn introduced into the mixer 5.

The evacuation is constituted as described below.

7 is a gate valve, which is opened when performing evacuation of a large volume such as during evacuation internally of the reaction tube 2 before formation of the deposited film. 8 is a slow leak valve, which is used when performing evacuation of a small volume such as in controlling the pressure internally of the reaction tube 2 during formation of the deposited film. 9 is an evacuation unit, which is constituted of a pump for evacuation such as turbo molecular pump, etc.

The conveying system of the substrate 1 is constituted as described below.

10 is a substrate conveying chamber which can house the substrate before and after formation of the deposited film, which is evacuated by opening the valve 11. 12 is an evacuation unit for evacuating the conveying chamber, which is constituted of a pump for evacuation such as turbo molecular pump, etc.

The valve 13 is opened only when the substrate 1 is transferred between the reaction chamber and the conveying space.

As shown in Fig. 1, in the starting gas gasifier 6 which is the gas formation chamber for forming the starting gas, the liquid DMAH maintained at room temperature is bubbled with $H_2$ or Ar (or other inert gas) as the carrier gas to form gaseous DMAH, which is transported to the mixer 5. The $H_2$ gas as the reaction gas is transported through another route into the mixer 5. The gases are controlled in flow rates so that the respective partial pressures may become desired values.

In the case of forming a film by this device, the first starting gas may be of course $MMAH_2$, but DMAH with a vapor pressure enough to become 1 Torr at room temperature is the most preferred. Also, DMAH and $MMAH_2$ may be used in a mixture.

As the second starting gas containing Si, there can be used $Si_2H_6$, $SiH_4$, $Si_3H_8$, $Si(CH_3)_4$, $SiCl_4$, $SiH_2Cl_2$ and $SiH_3Cl$. Of these compounds, $Si_2H_6$ which can be easily decomposed at the low temperature of 200 - 300 °C. The gases such as $Si_2H_6$ are diluted with $H_2$ or Ar and transported to the mixer 5 through a system other than the DMAH system.

The deposited film formed at a substrate temperature of 160 °C to 450 °C by use of such starting gas and reaction gas, with a thickness of for example 400 Å, has a resistivity at room temperature of 2.7 - 3.0 μohm•cm which is substantially equal to Al bulk resistivity, and is a continuous and flat film. At this time, the pressure during film formation can be chosen within the range from 0,1 to $10^5$ Pa ($10^{-3}$ Torr to 760 Torr). Also, even when the film thickness may be 1 μm, its resistivity is ca. 2.7 - 3.0 μohm•cm, and a sufficiently dense film can be formed also with a relatively thicker film. Also, the reflectance in the visible light wavelength region is approximately 80 %, whereby a thin film excellent in surface flatness can be deposited.

The substrate temperature is desirably the decomposition temperature of the starting gas containing Al or higher, and 450 °C or lower as described above, but specifically the substrate temperature of 200 to 450 °C is more desirable, and when deposition is carried out under this condition, by making the DMAH partial pressure 0.01 to 0.1 Pa ($10^{-4}$ to $10^{-3}$ Torr), the deposition speed becomes very great as 100 Å/min. to 800 Å/min., whereby sufficient great deposition speed corresponding to the cost as the Al-Si deposition technique for ultra-LSI can be obtained.

A more preferable substrate temperature condition is 270 °C to 350 °C, and the Al-Si film deposited under this condition is also strongly orientatable and, even when subjected to the heat treatment at 450 °C for 1 hour, the Al-Si film on the Si monocrystalline or Si polycrystalline substrate becomes a good Al-Si film without generation of hillock, spike as seen in the film forming method of the prior art. Also, such Al-Si film is excellent in electro-migration resistance.

In the device shown in Fig. 1, Al-Si can be deposited on only one sheet of substrate in deposition for one time. Although a deposition speed of ca. 800 Å/min. can be obtained, it is still insufficient for performing deposition of a large number of sheets within a short time.

As the deposition film forming device for improving this point, there is the low pressure CVD device which can deposit Al-Si by simultaneous mounting of a large number of sheets of wafer. Since the Al-Si film formation according to the present invention utilizes the surface reaction on the electron donative substrate surface, in the hot wall type low pressure CVD method wherein only the' substrate is heated, Al can be deposited on the substrate by use of DMAH and $H_2$ and the Si starting gas such as $Si_2H_6$, etc.

The reaction tube pressure may be 6.7 to $10^5$ Pa (0.05 to 760 Torr), desirably 13.3 to 106.7 Pa (0.1 to 0.8 Torr), the substrate temperature 160 °C to 450 °C, desirably 200 °C to 400 °C, the DMAH partial pressure $1 \times 10^{-5}$-fold to $1.3 \times 10^{-3}$-fold of the pressure in the reaction tube, the $Si_2H_6$ partial pressure $1 \times 10^{-7}$-fold to $1 \times 10^{-4}$-fold of the pressure in the reaction tube, and under such conditions, Al-Si can be well deposited on the electron donative substrate.

Fig. 2 is a schematic illustration showing a deposited film forming device to which such present invention is applicable.

57 is a substrate for formation of Al-Si film. 50 is an outside reaction tube made of quartz for forming a space for formation of deposited film substantially closed to the surrounding, 51 an innerside reaction tube made of quartz located for separating the flow of gas within the outside reaction tube 50, 54 a flange made of a metal for opening and closing of the opening of the outside reaction tube 50, and the substrate 57 is located within the substrate holding member 56 provided internally of the innerside reaction tube 51. The substrate holding member 56 should be preferably made of quartz.

Also, in the present device, the substrate temperature can be controlled by the heater portion 59. The pressure internally of the reaction tube 50 is constituted so as to be controllable by the evacuation system connected through the gas evacuation outlet 53.

The gas feeding system is constituted to have a first gas system, a second gas system, a third gas system and a mixer (none are shown in Fig. 2) similarly as the device shown by the symbols 5 and 6 in Fig. 1, and the starting gases and the reaction gas are introduced into the reaction tube 50 through the starting gas inlet 52. These gases react on the surface of the substrate 57 during passage internally of the innerside reaction tube 51 as shown by the arrowhead 58 in Fig. 2 to deposit Al-Si on the substrate surface. The gases after the reaction pass through the gap formed between the innerside reaction tube 51 and the outside reaction tube 50, and evacuated through the gas evacuation outlet 53.

In taking out and in the substrate, the flange 54 made of a metal is permitted to fall by an elevator (not shown) together with the substrate holding member 56 and the substrate 57 to be moved to a predetermined position where the substrate is mounted and detached.

By forming a deposited film under the conditions as described above by use of such device, Al-Si films of good quality can be formed in all the wafers within the device.

As described above, the film obtained according to the Al-Si film formation process based on the embodiment of the present invention is dense with little content of impurity such as carbon, etc. and resistivity which is similar to bulk, and also has high surface smoothness, and therefore remarkable effects as described below can be obtained.

(1) Reduction of hillock

Hillock is occurrence of concavities on the Al-Si surface due to partial migration of Al-Si when inner stress during film formation is released in the heat treatment step. Also, similar phenomenon occurs by local migration by current passage. The Al-Si film formed by the present invention has little inner stress and is approximate to the state of monocrystal. For this reason, in the heat treatment at 450 °C for one hour, as contrasted to formation of $10^4$ - $10^6$/cm$^2$ of hillocks in the Al-Si film of the prior art, the hillock number could be greatly improved as 0 to 10/cm$^2$. Thus, due to substantial absence of Al-Si surface concavity, the resist film thickness and the interlayer insulating film can be made thin to be advantageous for making it finer and more flat.

(2) Improvement of electro-migration resistance

Electro-migration is the phenomenon that the wiring atoms move by passage of a current of high density. By this phenomenon, voids are generated and grown along the grain boundary, whereby as accompanied with reduction of the cross-sectional area, the wiring generates heat to be broken. In the prior art, the anti-migration property has been improved by adding Cu, Ti, etc. to Al-Si to form an alloy. However, the alloy formation results in complication of the etching step and difficulty of minute formation.

Migration resistance is generally evaluated by average wiring life.

The wiring formed by the sputtering method or the CVD method of the prior art has obtained anaverage wiring life of 1 x $10^2$ to $10^3$ hours (in the case of a wiring cross-sectional area of 1 $\mu$m$^2$) under the current passage test conditions of 250 °C, 1 x $lo^6$ A/cm$^2$. In contrast, the Al-Si film obtained by the Al-Si film formation method based on the embodiment of the present invention could obtain an average wiring life of $10^3$ to $10^4$ hours with a wiring having a cross-sectional area of 1 $\mu$m$^2$.

Hence, according to the present invention, for example, when the wiring width is 0.8 $\mu$m, a wiring layer thickness of 0.3 $\mu$m can sufficiently stand practical application. That is, since the wiring layer thickness can be made thinner, unevenness on the semiconductor surface after arrangement of wiring can be suppressed minimum, and also high reliability in passing ordinary current can be obtained. Also, this is possible by a very simple process.

(3) Reduction of alloy pits in contact portion

By the heat treatment in the wiring step, eutectic reaction between Al in the wiring material and Si in the substrate may occur to result in penetration of Al-Si eutectic called as alloy pit into the substrate in spike pattern, thereby destroying shallow junction.

As countermeasure, it is general to employ a material other than pure Al when the depth of junction is 0.3 $\mu$m or more and to employ barrier metal technique of Ti, W, Mo type.

However, there remain some points to be improved such as complication of etching, rise of contact resistivity and the like. In Al-Si formed according to the present invention, generation of alloy pits in contact portion with substrate crystal due to heat treatment in the wiring step can be inhibited and wiring with good contact can also be obtained. In other words, wiring can be effected only with an Al-Si material without destroying junction even when the junction is formed in a depth of about 0.1 $\mu$m.

(4) Improvement of surface smoothness (patterning characteristic improvement of wiring)

In the prior art, roughness of the surface of a metal thin film had inconvenience in the alignment step for the mask and the substrate in the patterning step and in the etching step.

That is, there is unevenness extending to several µm on the surface of Al film according to the prior art method, whereby the surface morphology is poor, and therefore had the following disadvantages.

1) Alignment signals cause diffused reflection to occur at the surface, whereby noise level becomes higher and inherent alignment signals cannot be discriminated.

2) For covering large surface unevenness, the resist film thickness must be taken large, which is opposite to fine formation.

3) If the surface morphology is poor, halation due to the resist internal reflection will occur locally, whereby resist remaining occurs.

4) If the surface morphology is poor, the side wall becomes notched in the wiring etching step according to its unevenness.

According to the present invention, the surface morphology of Al-Si film to be formed is markedly improved to cancell all the drawbacks described above.

In other words, in the patterning step, at the line width of the resolving power limit of the exposure machine, the alignment precision 3 =0.15 µm can be accomplished, whereby wiring having smooth side plane is rendered possible without causing halation to occur.

(5) Improvement of resistance in contact hole and through hole and of contact resistance

In the prior art method, if the size of the contact hole becomes finer as 1 µm x 1 µm or less, Si in the wiring is precipitated on the substrate of the contact hole during heat treatment in the wiring step to cover thereover, whereby resistance between the wiring and the element becomes markedly larger.

According to the embodiment of the present invention, since a dense film is formed according to the surface reaction, Al-Si has been confirmed to have a resistivity of 2.7 - 3.3 µohm cm. Also, the contact resistivity can attain 1 x $10^{-6}$ ohm•$cm^2$ at an area of 0.6 µm x 0.6 µm when the Si portion has an impurity of $10^{20}$ $cm^{-3}$.

That is, according to the present invention, a good contact with the substrate can be obtained.

(6) It becomes possible to make heat treatment during wiring step lower or abolish the heat treatment step.

As described in detail above, by applying the present invention to the wiring formation method of a semiconductor integrated circuit, the yield can be improved, and reduction of cost can be promoted to great extent as compared with Al wiring of the prior art.

Figs. 3A - 3E show how the Al-Si film according to the present invention is selectively grown.

Fig. 3A is an illustration showing schematically the cross-section of the substrate before formation of the Al-Si deposited film according to the present invention. 90 is the substrate comprising an electron donative material, and 91 a thin film comprising an electron non-donative material.

In the case of using DMAH and $Si_2H_6$ as the starting gases, when a gas mixture containing $H_2$ as the reaction gas is fed onto the substrate 1 heated within a temperature range from the decomposition temperature of DMAH to 450 °C, Al is precipitated on the substrate 90, whereby a continuous film of Al is formed as shown in Fig. 3B. Here, the pressure within the reaction tube 2 should be desirably $10^{-1}$ to $10^5$ Pa ($10^{-3}$ to 760 Torr), and the DMAH partial pressure preferably 1.5 x $10^{-5}$ to 1.3 x $10^{-3}$-fold of the pressure within the above reaction tube. The $Si_2H_6$ partial pressure should preferably be 1 x $10^{-7}$ to 1 x $10^{-4}$-fold of the pressure within the reaction tube 2.

When deposition of Al-Si is continued under the above conditions, via the state of Fig. 3C, the Al-Si film grows to the level of the uppermost portion of the thin film 91 as shown in Fig. 3D. Further, when grown under the same conditions, as shown in Fig. 3E, the Al-Si film can grow to 5000 Å substantially without growth in the lateral direction. This is the most characteristic point of the deposited film obtained by the present invention, and it will be understood how a film of good quality can be formed under good selectivity.

As the result of analysis according to Auger's electron spectroscopy or photoelectric spectroscopy, no entrainment of an impurity such as carbon or oxygen is recognized in this film.

The deposited film thus formed has a resistivity of, for example, with a film thickness of 400 Å, 2.7 - 3.0 µohm•cm at room temperature which is substantially equal to the bulk resistivity of Al, and becomes continuous and flat film. Also, even with a film thickness of 1 µm, its resistance at room temperature is approximately 2.7 - 3.0 µohm•cm and a sufficiently dense film is, formed with a relatively thicker film. The reflectance in the visible wavelength region is approximately 80 %, and a thin film with excellent surface flatness can be deposited. The substrate temperature in performing such selective deposition should be desirably the decomposition temperature of the starting gas containing Al or higher and 450 °C or lower as

mentioned above, but specifically a substrate temperature of 200 to 450 °C is desirable, and when deposition is performed under such condition, the deposition speed is sufficiently great as 100 Å/min. to 800 Å/min. when DMAH partial pressure is 0.01 to 0.1 Pa ($10^{-4}$ to $10^{-3}$ Torr). Thus a sufficiently great deposition speed can be obtained as the Al-Si deposition technique for ultra-LSI.

A more preferable substrate temperature condition is 270 °C to 350 °C, and the Al-Si film deposited under this condition is also strongly orientatable and, even when subjected to the heat treatment at 450 °C for 1 hour, the Al-Si film on the Si monocrystalline or Si polycrystalline substrate becomes a good Al-Si film without generation of hillock, spike. Also, such Al-Si film is excellent in electro-migration resistance.

In the device shown in Fig. 1, Al-Si can be deposited on only one sheet of substrate in deposition for one time. Although a deposition speed of ca. 800 Å/min. can be obtained, it is still insufficient for performing deposition of a large number of sheets within a short time.

As the deposition film forming device for improving this point, there is the low pressure CVD device which can deposit Al-Si by simultaneous mounting of a large number of sheets of wafer. Since the Al-Si deposition according to the present invention utilizes the surface reaction of the electron donative substrate surface, in the hot wall type low pressure CVD method wherein only the substrate is heated, a Al-Si compound containing 0.5 to 2.0 % of Si can be deposited on the substrate by adding DMAH, $H_2$ and a Si starting gas such as $Si_2H_6$,etc.

The reaction tube pressure may be 6.7 to $10^5$ Pa (0.05 to 760 Torr), desirably 13.3 to 106.7 Pa (0.1 to 0.8 Torr), the substrate temperature 160 °C to 450 °C, desirably 200 °C to 400 °C, the DMAH partial pressure 1 x $10^{-5}$-fold to 1.3 x $10^{-3}$-fold of the pressure in the reaction tube, the $Si_2H_6$ partial pressure 1 x $10^{-7}$-fold to 1 x $10^{-4}$-fold of the pressure in the reaction tube, and under such conditions, Al-Si can be selectively deposited on only the electron donative substrate. In the case of such selective deposition, a good Al-Si film can also be formed under the above described conditions by use of the deposited film forming apparatus such as described above by referring to Figs. 1 and 2.

As described above, the film obtained according to the Al-Si film selective formation process based on the embodiment of the present invention is dense with very little content of impurity such as carbon, etc. and resistivity which is similar to bulk, and also has high surface smoothness, and therefore remarkable effects as described below can be obtained.

(1) Reduction of hillock

The Al-Si film formed according to the present invention has little internal stress and is approximate to the state of monocrystal. For this reason, in the heat treatment at 450 °C for one hour, as contrasted to formation of $10^4$ - $10^6$/cm$^2$ of hillocks in the Al-Si film of the prior art, the hillocks number could be greatly improved as 0 to 10/cm$^2$.

(2) Improvement of electro-migration resistance

In the prior art, the anit-migration property has been improved by adding Cu, Ti, etc. to Al-Si to form an alloy. However, the alloy formation results in complication of the etching step and difficulty of minute formation.

The wiring formed by the method of the prior art has obtained an average wiring life of 1 x $10^2$ to $10^3$ hours (in the case of a wiring cross-sectional area of 1 $\mu m^2$) under the current passage test conditions of 250 °C, 1 x $10^6$ A/cm$^2$. In contrast, the Al-Si film obtained by the Al-Si film selective formation method based on the embodiment of the present invention could obtain an average wiring life of $10^3$ to $10^4$ hours with a wiring having a cross-sectional area of 1 $\mu m^2$.

(3) Reduction of alloy pit in contact portion

The Al-Si selectively formed according to the present invention can suppress generation of alloy pit at the contact portion with the substrate crystal even by the heat treatment during wiring step, and also a wiring with good contact characteristic can be obtained. That is, even when the junction is made shallow to the extent of 0.1 $\mu$m, the junction will not be destroyed with only the Al-Si material.

(4) Improvement of surface smoothness (patterning characteristic improvement of wiring)

According to the present invention, the surface morphology of the Al-Si film to be formed can be improved epoch-makingly, whereby all of the problems of the prior art can be improved.

(5) Improvement of resistance in contact hole and through hole and contact resistance

According to the present invention, since adense film is selectively formed by the surface reaction even when the opening may be 1 μm x 1 μm or less, it has been confirmed that the Al-Si completely filled within the contact hole and through hole each has a resistivity of 2.7 - 3.3 μohm•cm. Also, the contact resistivity can attain 1 x $10^{-6}$ ohm•$cm^2$ in the case where the Si portion has an impurity of $10^{20}cm^{-3}$ in a hole of 0.6 μm x 0.6 μm.

That is, according to the present invention, the wiring material can be completely embedded only in the minute opening, and also good contact with the substrate can be obtained. Therefore, the present invention can contribute greatly to improvement of resistance within hole and contact resistance which have been the greatest problems in the fine process of 1 μm or less.

(6) It is possible to make the heat treatment temperature during wiring step lower or to omit the heat treatment step.

As described in detail above, by applying the present invention to the wiring formation method of a semiconductor integrated circuit, particularly embedding of contact hole or through hole, the yield can be improved, and reduction of cost can be promoted to great extent as compared with Al-Si wiring of the prior art.

Example 1

First, the procedure for Al-Si film formation is as follows. By use of the device shown in Fig. 1, the reaction tube 2 is internally evacuated to ca. 1.3 $10^{-6}$ Pa (1 x $10^{-8}$ Torr) by the evacuation unit 9. However, Al-Si film can be also formed if the vacuum degree within the reaction tube 2 may be worse than 1.3 $10^{-6}$ Pa (1 x $10^{-8}$ Torr).

After washing of Si wafer, the conveying chamber 10 is released to atmospheric pressure and Si wafer is mounted in the conveying chamber. The conveying chamber is evacuated to ca. 1.3 $10^{-4}$ Pa ($10^{-6}$ Torr), and then the gate valve 13 is opened and the wafer is mounted on the wafer holder 3.

After mounting of the wafer on the wafer holder 3, the gate valve 13 is closed, and the reaction chamber 2 is evacuated to a vacuum degree of ca. 1.3 $10^{-6}$ Pa (1 x $10^{-8}$ Torr).

In this Example, DMAH is fed through the first gas line. As the carrier gas of DMAH line $H_2$ which is the same as the reaction gas is employed. The second gas line is used for $H_2$ and the third gas line for $Si_2H_6$.

By passing $H_2$ through the second gas line, the pressure within the reaction tube 2 is made a predetermined value by controlling the opening of the slow leak valve 8. A typical pressure in this Example is made approximately 1.5 Torr. Then, the wafer is heated by current passage through the heater 4. After the wafer temperature has reached a predetermined temperature, DMAH and $Si_2H_6$ are introduced into the reaction tube through the DMAH line and the $Si_2H_6$ line. The total pressure is ca. 1.5 Torr, and the DMAH partial pressure is made ca. 1.95 $10^{-2}$ Pa (1.5 x $10^{-4}$ Torr). The $Si_2H_6$ partial pressure is made 2.6 $10^{-4}$ Pa (2 x $10^{-6}$ Torr). When $Si_2H_6$ and DMAH are introduced into the reaction tube 2, Al-Si is deposited. After a predetermined deposition time has elapsed, feeding of DMAH and $Si_2H_6$ is stopped. Next, heating of the heater 4 is stopped to cool the wafer. Feeding of $H_2$ gas is stopped, and after evacuation internally of the reaction tube, the wafer is transferred to the conveying chamber, and only the conveying chamber is made atmospheric before taking out the wafer. The outline of Al-Si film formation is as described above.

Experimental example 1

Al-Si films were deposited at the respective temperatures each for 10 sheet samples following the same procedure as described in Example 1 under the following conditions:

Total pressure: 1.5 Torr

DMAH partial pressure: 1.95 $10^{-2}$ Pa (1.5 x $10^{-4}$ Torr)

$Si_2H_6$ partial pressure: 2.6 $10^{-4}$ Pa (2 x $10^{-6}$ Torr).

The Al-Si films deposited by varying the substrate temperature at 13 levels were evaluated by use of various evaluation methods. The results are shown in Table 1.

It has been confirmed from the results that films of extremely excellent quality can be obtained within the temperature range of 160 to 450 °C, more preferably 200 to 400 °C, optimally 270 to 350 °C.

Table 1

| Evaluation item \ Substrate temperature (°C) | 150 | 160 | 200 | 250 | 270 | 300 | 330 | 350 | 370 | 400 | 430 | 450 | 470 |
|---|---|---|---|---|---|---|---|---|---|---|---|---|---|
| Carbon content (%) | – | 0 | 0 | 0 | 0 | 0 | 0 | 0 | 0 | 0 | 0 | 0 | 1 ~ 9 |
| Resistivity (μΩ · cm) | – | 2.7 ~ 3.3 | 2.7 ~ 3.3 | 2.7 ~ 3.3 | 2.7 ~ 3.3 | 2.7 ~ 3.3 | 2.7 ~ 3.3 | 2.7 ~ 3.3 | 2.7 ~ 3.3 | 2.7 ~ 3.3 | 2.7 ~ 3.3 | 2.7 ~ 3.3 | 2.7 ~ 3.3 |
| Reflectance (%) | – | 85~95 | 85~95 | 85~95 | 85~95 | 85~95 | 85~95 | 85~95 | 85~95 | 85~95 | 70 | 60 or lower | 60 or lower |
| Average wiring life (hour) | – | $10^3$ ~ $10^4$ | $10^3$ ~ $10^4$ | $10^3$ ~ $10^4$ | $10^3$ ~ $10^4$ | $10^3$ ~ $10^4$ | $10^3$ ~ $10^4$ | $10^3$ ~ $10^4$ | $10^3$ ~ $10^4$ | $10^3$ ~ $10^4$ | $10^2$ ~ $10^3$ | $10^2$ ~ $10^3$ | $10^2$ ~ $10^3$ |
| Deposition Speed (Å/min) | – | 1 ~ 9 | 100 ~ 800 | 100 ~ 800 | 100 ~ 800 | 100 ~ 800 | 100 ~ 800 | 100 ~ 800 | 100 ~ 800 | 100 ~ 800 | 100 ~ 800 | 100 ~ 800 | 1000 |
| Hillock density ($cm^{-2}$) | – | 0 ~ $10^3$ | 0 ~ $10^3$ | 0 ~ $10^3$ | 0 ~ 10 | 0 ~ 10 | 0 ~ 10 | 0 ~ 10 | 0 ~ $10^4$ | 0 ~ $10^4$ | 0 ~ $10^4$ | 0 ~ $10^4$ | 0 ~ $10^4$ |
| Spike generation ratio (%) | – | 0 ~ 10 | 0 ~ 10 | 0 | 0 | 0 | 0 | 0 | 0 ~ 30 | 0 ~ 30 | 0 ~ 30 | 0 ~ 30 | 0 ~ 30 |

Table 1 (continued)

Note: No deposition occurs at substrate temperature of 150 °C.

Average wiring life is time to wire breaking when current is passed at a current density of 1 x $10^6$ A/$cm^2$ through a cross-sectional area of 1 µ$m^2$ at 250 °C.

Spike generation ratio is destruction probability at the junction portion of 0.15 µm depth.

Experimental example 2

Following the same procedure as in Example 1 to set the parameters as follows:

Total pressure: 200 Pa (1.5 Torr)

DMAH partial pressure: 6.65 $10^{-2}$ Pa (5 x $10^{-4}$ Torr)

Substrate temperature (Tsub): 300 °C

and the $Si_2H_6$ partial pressure was varied from 2 $10^{-5}$ to 1.3 $10^{-2}$ Pa (1.5 x $10^{-7}$ Torr to 1 x $10^{-4}$ Torr) to effect deposition. The Si content (wt.%) of the Al-Si films were varied from 0.005 % to 5 % approximately in proportion to the $Si_2H_6$ partial pressure. As to resistivity, carbon content, average wiring life, deposition speed, hillock density and spike generation, the same results as in Experimental example 1 were obtained. However, in samples having a Si content of 4 % or higher, deposition was generated in the films which appeared to be Si to worsen surface morphology, thereby making the reflectance 65 % or lower. Samples having a Si content of less than 4 % exhibited a reflectance of 80 to 95 %, which was the same as in Experimental example 1.

Example 2

First, the procedure of Al-Si film formation is as follows. By the evacuation unit 9, the reaction tube is evacuated internally to ca. 1.3 $10^{-6}$ Pa (1 x $10^{-8}$ Torr). Al-Si film can be formed even if the vacuum degree in the reaction tube 2 may be higher than 1.3 $10^{-6}$ Pa (1 x $10^{-8}$ Torr).

After washing of the Si wafer, the conveying chamber 10 is released to atmospheric pressure and the Si wafer is mounted in the conveying chamber. The conveying chamber is evacuated to ca. 1.3 $10^{-4}$ Pa (1 x $10^{-6}$ Torr), then the gate valve 13 is opened and the wafer is mounted on the wafer holder 3.

After mounting of the wafer holder 3, the gate valve 13 is evacuated to a vacuum degree in the reaction chamber 2 of ca. 1.3 $10^{-6}$ Pa (1 x $10^{-8}$ Torr).

In this Example, the first gas line is used for DMAH. As the carrier gas for the DMAH line, Ar is employed. The second gas line is used for $H_2$. The third gas line is provided for $Si_2H_6$.

By passing $H_2$ through the second gas line, the pressure within the reaction tube 2 is made a predetermined value by controlling the opening of the slow leak valve 8. A typical pressure in this Example is made approximately 1.5 Torr. Then, the wafer is heated by current passage through the heater 4. After the wafer temperature has reached a predetermined temperature, DMAH and $Si_2H_6$ are introduced into the reaction tube through the DMAH line and the $Si_2H_6$ line. The total pressure is ca. 200 Pa (1.5 Torr), and the DMAH partial pressure is made ca. 2 $10^{-2}$ Pa (1.5 x $10^{-4}$ Torr). The $Si_2H_6$ partial pressure is made 2.67 $10^{-3}$ Pa (2 x $10^{-5}$ Torr). When $Si_2H_6$ and DMAH are introduced into the reaction tube 2, Al-Si is deposited. After a predetermined deposition time has elapsed, feeding of DMAH and $Si_2H_6$ is stopped. Next, heating of the heater 4 is stopped to cool the wafer. Feeding of $H_2$ gas is stopped, and after evacuation internally of the reaction tube, the wafer is transferred to the conveying chamber, and only the conveying chamber is made atmospheric pressure before taking out the wafer. The outline of Al-Si film formation is as described above.

Experimental example 3

For deposited films formed according to the method of Example 2, concerning resistivity, carbon content, average wiring life, deposition speed, hillock density, generation of spike and reflectance, the same results as in Example 1 were obtained.

Experimental example 4

Following the same procedure as in Example 2 to set the parameters as follows:

Total pressure: 200 Pa (1.5 Torr)

DMAH partial pressure: 6.65 $10^{-2}$ Pa (5 x $10^{-4}$ Torr)

Substrate temperature (Tsub): 300 °C

and the $Si_2H_6$ partial pressure was varied from 2 $10^{-5}$ to 1.3 $10^{-2}$ Pa (1.5 x $10^{-7}$ Torr to 1 x $10^{-4}$ Torr) to effect deposition. The Si content (wt.%) of the Al-Si films were varied from 0.005 % to 5 % approximately in proportion to the $Si_2H_6$ partial pressure. As to resistivity, carbon content, average wiring life, deposition speed, hillock density and spike generation, the same results as in Experimental example 1 were obtained. However, in samples having a Si content of 4 % or higher, deposition was generated in the films which appeared to be Si to worsen surface morphology, thereby making the reflectance 65 % or lower. Samples having a Si content of less than 4 % exhibited a reflectance of 80 to 95 %, which was the same as in Experimental example 1.

Example 3

This Example 3 is film formation according to the low pressure CVD method.

Experimental example 5

A silicon substrate was placed in the low pressure CVD method shown in Fig. 2, and Al-Si film was formed within the same badge. The film formation conditions were made a reaction tube pressure of 0.3 Torr, a DMAH partial pressure of 4 $10^{-3}$ Pa (3.0 x $10^{-5}$ Torr), a $Si_2H_6$ partial pressure of 1.33 $10^{-4}$ Pa (1.0 x $10^{-6}$ Torr), a substrate temperature of 300 °C, and a film formation time of 10 minutes.

As the result of film formation under such conditions, an Al-Si film of 7000 Å was deposited. The film quality was very good, exhibiting the sameproperties as one prepared at a substrate temperature of 300 °C

shown in Experimental example 1.

Example 4

This Example 4 shows a film formation method using $MMAH_2$ in place of DMAH.

Experimental example 6

The procedure of Example 1 was repeated to effect deposition with the exception that $MMAH_2$ was used as the starting gas and the parameters were set as follows:

Total pressure: 200 Pa (1.5 Torr)
$MMAH_2$ partial pressure: 6.65 $10^{-2}$ Pa (5 x $10^{-4}$ Torr)
$Si_2H_6$ partial pressure: 1.33 $10^{-3}$ Pa (1.0 x $10^{-5}$ Torr)

As a result, Al-Si thin films were deposited within the substrate temperature range of 160 °C to 400 °C which contained no carbon impurity and were excellent in flatness and denseness similarly as in Experimental example 1.

Example 5

This Example 5 performs deposition using a gas other than $Si_2H_6$ as a gas of the compound containing silicon atoms.

Experimental example 7

The procedure of Example 1 was repeated to effect deposition with the exception that $SiH_4$ was used in place of $Si_2H_6$ as the starting material containing Si and the parameters were set as follows:

Total pressure: 200 Pa (1.5 Torr)
DMAH partial pressure: 6.65 $10^{-2}$ Pa (5 x $10^{-4}$ Torr)
$SiH_4$ partial pressure: 1.33 $10^{-3}$ Pa (1 x $10^{-5}$ Torr)

As a result, Al-Si thin films were deposited within the substrate temperature range of 160 °C to 400 °C which contained no carbon impurity and were excellent in flatness and denseness similarly as in Experimental example 1.

Examples 6 to 8 and Experimental examples 8 to 15 described below are examples when forming Al-Si films selectively.

Example 6

In this Example 6, selective deposition of Al-Si is effected by use of the device shown in Fig. 1. The reaction tube 2 is internally evacuated to ca. 1.33 $10^{-6}$ Pa (1 x $10^{-8}$ Torr) by the evacuation unit 9. However, Al-Si film can be also formed even if the vacuum degree within the reaction tube 2 may be worse than 1.33 $10^{-6}$ Pa (1 x $10^{-8}$ Torr).

After washing of the Si wafer, the conveying chamber 10 is released to atmospheric pressure and the Si wafer is mounted in the conveying chamber. The conveying chamber is evacuated to ca. 1.33 $10^{-4}$ Pa (1 x $10^{-6}$ Torr), then the gate valve 13 is opened and the wafer is mounted on the wafer holder 3.

After mounting of the wafer on the wafer holder 3, the gate valve 13 is closed, and the reaction chamber 2 is evacuated to a vacuum degree of ca. 1.33 $10^{-6}$ Pa (1 x $10^{-8}$ Torr).

In this Example, DMAH is fed through the first gas line. As the carrier gas of DMAH line, $H_2$ is employed. The second gas line is used for $H_2$ and the third gas line for $Si_2H_6$. By passing $H_2$ through the second gas line, the pressure within the reaction tube 2 is made a predetermined value by controlling the opening of the slow leak valve 8. A typical pressure in this Example is made approximately 200 Pa (1.5 Torr). Then, the wafer is heated by current passage through the heater 4. After the wafer temperature has reached a predetermined temperature, DMAH and $Si_2H_6$ are introduced into the reaction tube through the DMAH line and the $Si_2H_6$ line. The total pressure is ca. 200 Pa (1.5 Torr), and the DMAH partial pressure is made ca. 2 $10^{-2}$ Pa (1.5 x $10^{-4}$ Torr). The $Si_2H_6$ partial pressure is made 2.66 $10^{-4}$ Pa (2 x $10^{-6}$ Torr). When $Si_2H_6$ and DMAH are introduced into the reaction tube 2, Al-Si is deposited. After a predetermined deposition time has elapsed, feeding of DMAH and $Si_2H_6$ is stopped. Next, heating of the heater 4 is stoppedto cool the wafer. Feeding of $H_2$ gas is stopped, and after evacuation internally of the reaction tube, the wafer is transferred to the conveying chamber, and only the conveying chamber is made atmospheric

before taking out the wafer. The outline of Al-Si film formation is as described above.

Experimental example 8

Si substrates (N type, 1 - 2 ohm•cm) were subjected to thermal oxidation at a temperature of 1000 °C according to the hydrogen combustion system ($H_2$: 4 liters/M, $O_2$: 2 liters/M).

The film thickness was 7000 Å ± 500 Å, and the refractive index 1.46. A photoresist was coated on the whole Si substrate, and a desired pattern was baked by an exposure machine. The pattern was such that various holes of 0.25 µm x 0.25 µm - 100 µm x 100 µm were opened. After development of the resist, with the photoresist as the mask, the subbing $SiO_2$ was etched by the reactive ion etching (RIE), etc. to have the substrate Si partially exposed. Thus, 130 sheets of samples having various sizes of $SiO_2$ holes of 0.25 µm x 0.25 µm - 100 µm x 100 µm were prepared, the substrate temperature was set at 13 levels, and for the samples each of 10 sheets at the respective temperatures, Al-Si films were selectively deposited following the procedure as described above under the following conditions:

Total pressure: 200 Pa (1.5 Torr)

DMAH partial pressure: 2 $10^{-2}$ Pa (1.5 x $10^{-4}$ Torr)

$Si_2H_6$ partial pressure: 2.67 $10^{-3}$ Pa (2 x $10^{-6}$ Torr)

The Al-Si films deposited by varying the substrate temperature at 13 levels were evaluated by use of various evaluation methods. The results are shown in Table 2.

Table 2

| Evaluation item \ Substrate temperature (°C) | 150 | 160 | 200 | 250 | 270 | 300 | 330 | 350 | 370 | 400 | 430 | 450 | 470 |
|---|---|---|---|---|---|---|---|---|---|---|---|---|---|
| Carbon content (%) | − | 0 | 0 | 0 | 0 | 0 | 0 | 0 | 0 | 0 | 0 | 0 | 1 ~ 9 |
| Resistivity (μΩ·cm) | − | 2.7 ~ 3.3 | 2.7 ~ 3.3 | 2.7 ~ 3.3 | 2.7 ~ 3.3 | 2.7 ~ 3.3 | 2.7 ~ 3.3 | 2.7 ~ 3.3 | 2.7 ~ 3.3 | 2.7 ~ 3.3 | 2.7 ~ 3.3 | 2.7 ~ 3.3 | 2.7 ~ 3.3 |
| Reflectance (%) | − | 85~95 | 85~95 | 85~95 | 85~95 | 85~95 | 85~95 | 85~95 | 85~95 | 85~95 | 70 | 60 or lower | 60 or lower |
| Average wiring life (hour) | − | $10^3$ ~ $10^4$ | $10^3$ ~ $10^4$ | $10^3$ ~ $10^4$ | $10^3$ ~ $10^4$ | $10^3$ ~ $10^4$ | $10^3$ ~ $10^4$ | $10^3$ ~ $10^4$ | $10^3$ ~ $10^4$ | $10^3$ ~ $10^4$ | $10^2$ ~ $10^3$ | $10^2$ ~ $10^3$ | $10^2$ ~ $10^3$ |
| Deposition Speed (Å/min) | − | 1 ~ 9 | 100 ~ 800 | 100 ~ 800 | 100 ~ 800 | 100 ~ 800 | 100 ~ 800 | 100 ~ 800 | 100 ~ 800 | 100 ~ 800 | 100 ~ 800 | 100 ~ 800 | 1000 |
| Hillock density ($cm^{-2}$) | − | 0 ~ $10^3$ | 0 ~ $10^3$ | 0 ~ $10^3$ | 0 ~ 10 | 0 ~ 10 | 0 ~ 10 | 0 ~ 10 | 0 ~ $10^4$ | 0 ~ $10^4$ | 0 ~ $10^4$ | 0 ~ $10^4$ | 0 ~ $10^4$ |
| Spike generation ratio (%) | − | 0 ~ 10 | 0 ~ 10 | 0 | 0 | 0 | 0 | 0 | 0 ~ 30 | 0 ~ 30 | 0 ~ 30 | 0 ~ 30 | 0 ~ 30 |

Table 2 (continued)

Note: No deposition occurs at substrate temperature of 150 °C.

: Average wiring life is time to wire breaking when current is passed at a current density of 1 x $10^6$ A/$cm^2$ through a cross-sectional area of 1 $\mu m^2$ at 250 °C.

Spike generation ratio is destruction probability at the junction portion of 0.15 μm depth.

In the above samples, no Al-Si was deposited on $SiO_2$ at a temperature range from 160 °C to 450 °C, and Al-Si was deposited only on the portion with opening of $SiO_2$ to have Si exposed. Also, when deposition was carried out in the above temperature range continuously for 2 hours, similar selective depositablity was maintained.

Experimental example 9

Following the same procedure as in Example 1 to set the parameters as follows:
Total pressure: 200 Pa (1.5 Torr)
DMAH partial pressure: 6.65 $10^{-2}$ Pa (5 x $10^{-4}$ Torr)
Substrate temperature (Tsub): 300 °C
and the $Si_2H_6$ partial pressure was varied from 2 $10^{-5}$ to 1.3 $10^{-2}$ Pa (1.5 x $10^{-7}$ Torr to 1 x $10^{-4}$ Torr) to effect deposition. The Si content (wt.%) of the Al-Si films were varied from 0.005 % to 5 % approximately in proportion to the $Si_2H_6$ partial pressure. As to resistivity, carbon content, average wiring life, deposition speed, hillock density and spike generation, the same results as in Experimental example 8 were obtained. However, in samples having a Si content of 4 % or higher, deposition was generated in the films which appeared to be Si to worsen surface morphology, thereby making the reflectance 65 % or lower. Samples having a Si content of less than 4 % exhibited a reflectance of 80 to 95 %, which was the same as in

Experimental example 8.

Furthermore, similarly as in Experimental example 8 selective depositability depending on substrate surface material was also confirmed over the entire region.

Example 7

First, the procedure of Al-Si film formation is as follows. By the evacuation unit 9, the reaction tube 2 is evacuated internally to ca. 1.3 $10^{-6}$ Pa (1 x $10^{-8}$ Torr). Al-Si film can be formed even if the vacuum degree in the reaction tube 2 may be worse than 1.3 $10^{-6}$ Pa (1 x $10^{-8}$ Torr).

After washing of the Si wafer, the conveying chamber 10 is released to atmospheric pressure and the Si wafer is mounted in the conveying chamber. The conveying chamber is evacuated to ca. 1.3 $10^{-4}$ Pa (1 x $10^{-6}$ Torr), then the gate valve 13 is opened and the wafer is mounted on the wafer holder 3.

After mounting of the wafer holder 3, the gate valve 13 is closed and evacuated to a vacuum degree in the reaction chamber 2 of ca. 1.3 $10^{-6}$ Pa (1 x $10^{-8}$ Torr).

In this Example, the first gas line is used for DMAH. As the carrier gas for the DMAH line, Ar is employed. The second gas line is used for $H_2$. The third gas line is provided for $Si_2H_6$.

By passing $H_2$ through the second gas line, the pressure within the reaction tube 2 is made a predetermined value by controlling the opening of the slow leak valve 8. A typical pressure in this Example is made approximately 200 Pa (1.5 Torr). Then, the wafer is heated by current passage through the heater 4. After the wafer temperature has reached a predetermined temperature, DMAH and $Si_2H_6$ are introduced into the reaction tube through the DMAH line and the $Si_2H_6$ line. The total pressure is ca. 200 Pa (1.5 Torr), and the DMAH partial pressure is made ca. 2 $10^{-2}$ Pa (1.5 x $10^{-4}$ Torr). When $Si_2H_6$ and DMAH are introduced into the reaction tube 2, Al-Si is deposited. After a predetermined deposition time has elapsed, feeding of DMAH and $Si_2H_6$ is stopped. Next, heating of the heater 4 is stopped to cool the wafer. Feeding of $H_2$ gas is stopped, and after evacuation internally of the reaction tube, the wafer is transferred to the conveying chamber, and only the conveying chamber is made atmospheric before taking out the wafer. The outline of Al-Si film formation is as described above.

Experimental example 10

Al-Si films were formed according to the method of Example 7. For the deposited films obtained, concerning resistivity, carbon content, average wiring life, deposition speed, hillock density, generation of spike and reflectance, the same results as in Experimental example 8 were obtained.

Also, selective depositability with substrate was the same as in Experimental example 8.

Experimental example 11

Following the same procedure as in Example 7 to set the parameters as follows:

Total pressure: 200 Pa (1.5 Torr)

DMAH partial pressure: 6.65 $10^{-2}$ Pa (5 x $10^{-4}$ Torr)

Substrate temperature (Tsub): 300 °C

and the $Si_2H_6$ partial pressure was varied from 2 $10^{-5}$ to 1.3 $10^{-2}$ Pa (1.5 x $10^{-7}$ Torr to 1 x $10^{-4}$ Torr) to effect deposition. The Si content (wt.%) of the Al-Si films were varied from 0.005 % to 5 % approximately in proportion to the $Si_2H_6$ partial pressure. As to resistivity, carbon content, average wiring life, deposition speed, hillock density and spike generation, the same results as in Experimental example 8 were obtained. However, in samples having a Si content of 4 % or higher, deposition was generated in the films which appeared to be Si to worsen surface morphology, thereby making the reflectance 65 % or lower. Samples having a Si content of less than 4 % exhibited a reflectance of 80 to 95 %, which was the same as in Experimental example 8. Furthermore, similarly as in Experimental example 8, selective depositability depending on substrate surface material was also confirmed over the entire region.

Example 8

This Example is selective deposition of Al-Si according to the low pressure CVD method.

Experimental example 12

By means of the reduced pressure CVD device shown in Fig. 2, Al-Si films were formed on the substrates with the constitutions as described below (Samples 5-1 - 5-179).

Preparation of Sample 5-1

On a monocrystalline silicon as the electron donative first substrate surface material, a thermally oxidized $SiO_2$ film as the electron non-donative second substrate surface material was formed, and patterning was effected according to the photolithographic steps as shown in Experimental example 8 to have the monocrystalline silicon surface partially exposed.

The film thickness of the thermally oxidized $SiO_2$ film was found to be 7000 Å, with the size of the exposed portion of the monocrystalline silicon, namely opening being 3 µm x 3 µm. Thus, Sample 5-1 was prepared. (Hereinafter, such sample is expressed as "thermally oxidized $SiO_2$ (hereinafter abbreviated as T-$SiO_2$)/monocrystalline silicon").

Preparation of Samples 5-2 - 5-179

Sample 5-2 is an oxidized film formed by normal pressure CVD (hereinafter abbreviated as $SiO_2$)-/monocrystalline silicon.

Sample 5-3 is a boron doped oxidized film formed by normal pressure CVD (hereinafter abbreviated as BSG)/monocrystalline silicon.

Sample 5-4 is a phosphorus doped oxidized film formed by normal pressure CVD (hereinafter abbreviated as PSG)/monocrystalline silicon.

Sample 5-5 is a phosphorus and boron doped oxidized film formed by normal pressure CVD (hereinafter abbreviated as BSPG)/monocrystalline silicon formed by normal pressure CVD.

Sample 5-6 is a nitrided film formed by plasma CVD (hereinafter abbreviated as P-S:N)/monocrystalline silicon.

Sample 5-7 is a thermally nitrided film (hereinafter abbreviated as T-S:N)/monocrystalline silicon.

Sample 5-8 is a nitrided film formed by low pressure CVD (hereinafter abbreviated as LP-S:N)-/monocrystalline silicon.

Sample 5-9 is a nitrided film formed by ECR device (hereinafter abbreviated as ECR-SiN)-/monocrystalline silicon.

Further, by combinations of the electron donative first substrate surface materials and the electron non-donative second substrate surface materials, Samples 5-11 - 5-179 shown in Table 3 were prepared. As the first substrate surface material, monocrystalline silicon (monocrystalline Si), polycrystalline silicon (polycrystalline Si), amorphous silicon (amorphous Si), tungsten (W), molybdenum (Mo), tantalum (Ta), tungsten silicide (WSi), titanium silicide (TiSi), aluminum (Al), aluminum silicon (Al-Si), titanium aluminum (Al-Ti), titanium nitride (TiN), copper (Cu), aluminum silicon copper (Al-Si-Cu), aluminum palladium (Al-Pd), titanium (Ti), molybdenum silicide (Mo-Si), tantalum silicide (Ta-Si) were employed. These samples and $Al_2O_3$ substrates, $SiO_2$ glass substrates were placed in the low pressure CVD device shown in Table 2, and Al-Si films were formed within the same badge. The film forming conditions were a reaction tube pressure of 40 Pa (0.3 Torr), a DMAH partial pressure of 4 $10^{-2}$ Pa (3.0 x $10^{-5}$ Torr), a $Si_2H_6$ partial pressure of 1.3 $10^{-4}$ Pa (1.0 x $10^{-6}$ Torr), a substrate temperature of 300 °C and a film formation time of 10 minutes.

As the result of film formation under such conditions, concerning all the samples applied with patterning from Sample 5-1 to 5-179, deposition of Al-Si film occurred only on the electron donative first substrate surface film to embed completely the opening with the depth of 7000 Å. The film quality of the Al-Si film was found to be very good, exhibiting the same properties as one prepared at a substrate temperature of 300 °C shown in Experimental example 8. On the other hand, on the second substrate surface which is electron non-donative, no Al-Si film was deposited at all, whereby complete selectivity was obtained. On both the $Al_2O_3$ substrate and the $SiO_2$ glass substrate which are electron non-donative, no Al-Si film was deposited at all.

Experimental example 13

By use of the low pressure CVD device shown in Fig. 2, Al-Si film was formed on the substrate with the constitution as described below.

On a thermally oxidized film as the electron non-donative second substrate surface material, a polycrystalline Si as the electron donative first substrate surface material was formed, patterning was effected according to the photolithographic steps as shown in Experimental example 8 to have the thermally oxidized film surface partially exposed. The film thickness of the polycrystalline silicon at this time was 2000 Å, with the size of the thermally oxidized film exposed portion, namely opening being 3 µm x 3 µm. Such sample is called 6-1. By combinations of the electron non-donative second substrate surface materials (T-$SiO_2$, CVD-$SiO_2$, BSG, PSG, BPSG, P-SiN, T-SiN, LP-SiN, ECR-S:N) and the electron-donative first substrate surface materials (polycrystalline Si, amorphous Si, Al, W, Mo, Ta, WSi, TiSi, TaSi, Al-Si, Al-Ti, TiN, Cu, Al-Si-Cu, Al-Pd, Ti, Mo-Si), Samples of 6-1 - 6-169 shown in Table 4 were prepared. These samples were placed in the low CVD device shown in Fig. 2, and Al-Si film was formed within the same badge. The film forming conditions were a reaction tube pressure of 0.3 Torr, a DMAH partial pressure of 4 $10^{-3}$ Pa (3.0 x $10^{-5}$ Torr), a $Si_2H_6$ partial pressure of 1.3 $10^{-4}$ Pa (1.0 x $10^{-6}$ Torr), a substrate temperature of 300 °C and a film forming time of 10 minutes. As the result of film formation under such conditions, in all the samples from 6-1 to 6-169, no Al-Si film was deposited at all at the opening having the electron non-donative second substrate exposed, but Al-Si of about 7000 Å was deposited only on the electron donative first substrate, whereby complete selectivity was obtained. The film quality of the Al-Si film deposited was found to be very good, exhibiting the same properties as one prepared at a substrate temperature of 300 °C in Experimental example 8.

Table 3

| | Mono-crystalline Si | Poly-Crystalline Si | Amorphous Si | W | Mo | Ta | WSi | TiSi | Aℓ | AℓSi |
|---|---|---|---|---|---|---|---|---|---|---|
| T-$SiO_2$ | 5-1 | 5-11 | 5-21 | 5-31 | 5-41 | 5-51 | 5-61 | 5-71 | 5-81 | 5-91 |
| $SiO_2$ | 5-2 | 5-12 | 5-22 | 5-32 | 5-42 | 5-52 | 5-62 | 5-72 | 5-82 | 5-92 |
| BSG | 5-3 | 5-13 | 5-23 | 5-33 | 5-43 | 5-53 | 5-63 | 5-73 | 5-83 | 5-93 |
| PSG | 5-4 | 5-14 | 5-24 | 5-34 | 5-44 | 5-54 | 5-64 | 5-74 | 5-84 | 5-94 |
| BPSG | 5-5 | 5-15 | 5-25 | 5-35 | 5-45 | 5-55 | 5-65 | 5-75 | 5-85 | 5-95 |
| P-SiN | 5-6 | 5-16 | 5-26 | 5-36 | 5-46 | 5-56 | 5-66 | 5-76 | 5-86 | 5-96 |
| T-SiN | 5-7 | 5-17 | 5-27 | 5-37 | 5-47 | 5-57 | 5-67 | 5-77 | 5-87 | 5-97 |
| LP-SiN | 5-8 | 5-18 | 5-28 | 5-38 | 5-48 | 5-58 | 5-68 | 5-78 | 5-88 | 5-98 |
| ECR-SiN | 5-9 | 5-19 | 5-29 | 5-39 | 5-49 | 5-59 | 5-69 | 5-79 | 5-89 | 5-99 |

Table 3 (continued)

| | Aℓ Ti | Ti-N | Cu | Aℓ -Si-Cu | Aℓ Pd | Ti | Mo-Si | Ta-Si |
|---|---|---|---|---|---|---|---|---|
| T-$SiO_2$ | 5-101 | 5-111 | 5-121 | 5-131 | 5-141 | 5-151 | 5-161 | 5-171 |
| $SiO_2$ | 5-102 | 5-112 | 5-122 | 5-132 | 5-142 | 5-152 | 5-162 | 5-172 |
| BSG | 5-103 | 5-113 | 5-123 | 5-133 | 5-143 | 5-153 | 5-163 | 5-173 |
| PSG | 5-104 | 5-114 | 5-124 | 5-134 | 5-144 | 5-154 | 5-164 | 5-174 |
| BPSG | 5-105 | 5-115 | 5-125 | 5-135 | 5-145 | 5-155 | 5-165 | 5-175 |
| P-SiN | 5-106 | 5-116 | 5-126 | 5-136 | 5-146 | 5-156 | 5-166 | 5-176 |
| T-SiN | 5-107 | 5-117 | 5-127 | 5-137 | 5-147 | 5-157 | 5-167 | 5-177 |
| LP-SiN | 5-108 | 5-118 | 5-128 | 5-138 | 5-148 | 5-158 | 5-168 | 5-178 |
| ECR-SiN | 5-109 | 5-119 | 5-129 | 5-139 | 5-149 | 5-159 | 5-169 | 5-179 |

(note) Numeral shows sample No.

Table 4

| | Poly-Crystalline Si | Amorphous Si | W | Mo | Ta | WSi | TiSi | Al | AlSi |
|---|---|---|---|---|---|---|---|---|---|
| T-$SiO_2$ | 6-1 | 6-11 | 6-21 | 6-31 | 6-41 | 6-51 | 6-61 | 6-71 | 6-81 |
| $SiO_2$ | 6-2 | 6-12 | 6-22 | 6-32 | 6-42 | 6-52 | 6-62 | 6-72 | 6-82 |
| BSG | 6-3 | 6-13 | 6-23 | 6-33 | 6-43 | 6-53 | 6-63 | 6-73 | 6-83 |
| PSG | 6-4 | 6-14 | 6-24 | 6-34 | 6-44 | 6-54 | 6-64 | 6-74 | 6-84 |
| BPSG | 6-5 | 6-15 | 6-25 | 6-35 | 6-45 | 6-55 | 6-65 | 6-75 | 6-85 |
| P-SiN | 6-6 | 6-16 | 6-26 | 6-36 | 6-46 | 6-56 | 6-66 | 6-76 | 6-86 |
| T-SiN | 6-7 | 6-17 | 6-27 | 6-37 | 6-47 | 6-57 | 6-67 | 6-77 | 6-87 |
| LP-SiN | 6-8 | 6-18 | 6-28 | 6-38 | 6-48 | 6-58 | 6-68 | 6-78 | 6-88 |
| ECR-SiN | 6-9 | 6-19 | 6-29 | 6-39 | 6-49 | 6-59 | 6-69 | 6-79 | 6-89 |

Table 4 (continued)

| | AlTi | Ti-N | Cu | Al-Si-Cu | AlPd | Ti | Mo-Si | Ta-Si |
|---|---|---|---|---|---|---|---|---|
| T-$SiO_2$ | 6-91 | 6-101 | 6-111 | 6-121 | 6-131 | 6-141 | 6-151 | 6-161 |
| $SiO_2$ | 6-92 | 6-102 | 6-112 | 6-122 | 6-132 | 6-142 | 6-152 | 6-162 |
| BSG | 6-93 | 6-103 | 6-113 | 6-123 | 6-133 | 6-143 | 6-153 | 6-163 |
| PSG | 6-94 | 6-104 | 6-114 | 6-124 | 6-134 | 6-144 | 6-154 | 6-164 |
| BPSG | 6-95 | 6-105 | 6-115 | 6-125 | 6-135 | 6-145 | 6-155 | 6-165 |
| P-SiN | 6-96 | 6-106 | 6-116 | 6-126 | 6-136 | 6-146 | 6-156 | 6-166 |
| T-SiN | 6-97 | 6-107 | 6-117 | 6-127 | 6-137 | 6-147 | 6-157 | 6-167 |
| LP-SiN | 6-98 | 6-108 | 6-118 | 6-128 | 6-138 | 6-148 | 6-158 | 6-168 |
| ECR-SiN | 6-99 | 6-109 | 6-119 | 6-129 | 6-139 | 6-149 | 6-159 | 6-169 |

(note) Numeral shows sample No.

Experimental example 14

When deposition was carried out according to the same procedure as shown in Experimental example 8 by use of $MMAH_2$ as the starting gas and setting the conditions as follows:

Total pressure: 200 Pa (1.5 Torr)

$MMAH_2$ partial pressure: 6.65 $10^{-2}$ Pa (5 x $10^{-4}$ Torr),

$Si_2H_6$ partial pressure: 1.3 $10^{-3}$ Pa (1 x $10^{-5}$ Torr)

in the temperature range of the substrate temperature from 160 °C to 400 °C, an Al-Si thin film containing no carbon impurity and having excellent flatness, denseness and selectivity with the substrate surface materials was deposited similarly as in Experimental example 8.

Experimental example 15

When deposition was carried out by following the procedure of Experimental example 8, but substituting $SiH_4$ for $Si_2H_6$ as the starting material containing Si and setting the conditions as follows:

Total pressure: 200 Pa (1.5 Torr)
DMAH partial pressure: 6.65 $10^{-2}$ Pa (5 x $10^{-4}$ Torr),
$SiH_4$ partial pressure: 1.3 $10^{-3}$ Pa (1 x $10^{-5}$ Torr)

in the temperature range of the substrate temperature from 160 °C to 400 °C, an Al-Si thin film containing no carbon impurity and having excellent flatness, denseness and selectivity with the substrate surface materials was deposited similarly as in Experimental example 8.

Comparative experiment

An Al film was formed on a monocrystalline silicon under the following conditions.

By passing Ar in place of $H_2$, Al was deposited by pyrolysis of DMAH. The total pressure at this time was made 200 Pa (1.5 Torr), the DMAH partial pressure 2 $10^{-2}$ Pa (1.5 x $10^{-4}$ Torr), and the substrate temperature of 270 - 350 °C.

When the Al film thus formed was evaluated, about 2 % of carbon was found to be contained at the minimum.

Resistivity became greater by 2-fold or more than the case when hydrogen was employed.

As to reflectance, it was lowered to about 1/3 to 1/9 relative the case when hydrogen was employed.

Similarly, wiring life was shorter by 1 to 2 cipher, generation probability of hillock became greater by 2 cipher or more, and a large number of spikes were found to be generated.

As to the deposition speed, it was lowered to 1/2 to 1/4.

As described above, Al deposited only by decomposition of DMAH without use of $H_2$ is inferior in film quality, and was unsatisfactory as the Al film for a semiconductor device.

Separately, without use of $H_2$, DMAH was decomposed by the optical CVD method to deposit Al. As the result, some improvement such as no containment of carbon, and the like was observed from as the Al film prepared as compared with the case when no light was employed, but other characteristics were not improved so much, and the Al film was still unsatisfactory as the Al film for a semiconductor device.

As described above, the mechanism of Al deposition according to the present invention may be presently hypothesized as follows.

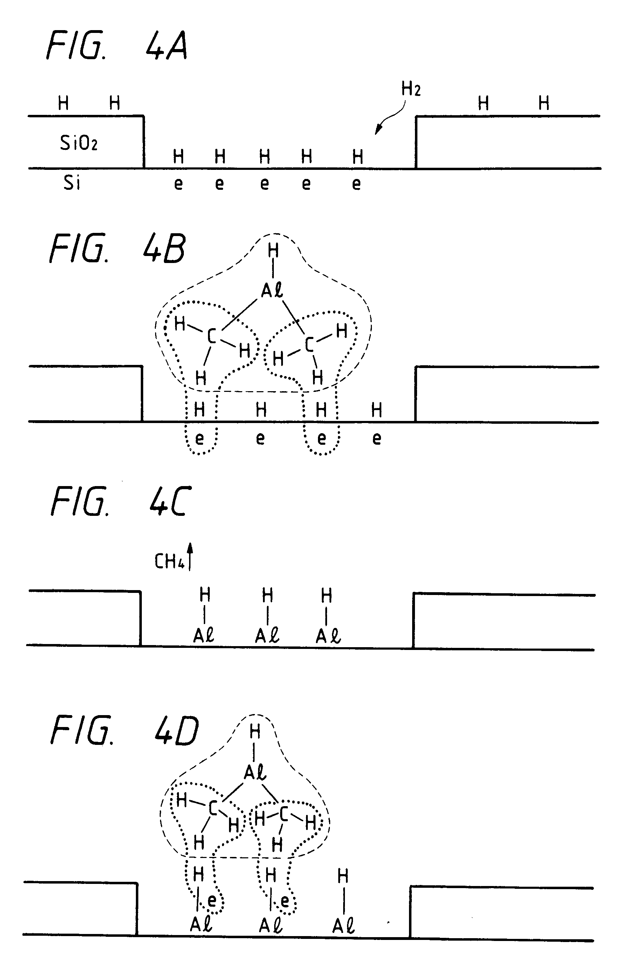

When DMAH reaches the electron donative substrate, namely the substrate having electrons under the state on which hydrogen atoms are attached (Fig. 4A) with the methyl groups directed toward the substrate side, one electron of the substrate cuts one bond of Al and a methyl group (Figs. 4B and 4C).

The reaction scheme at this time is as follows:

$$(CH_3)_2AlH + 2H + 2e \rightarrow 2CH_4 \uparrow + Al\text{-}H$$

Further, similar reactions will proceed for the hydrogen atoms remaining on deposited Al having free electrons (Fig. 4D). Here, when hydrogen atoms are deficient, hydrogen molecules constituting the reaction gas are decomposed on the substrate to supply hydrogen atoms. On the other hand, since there is no electron on the electron non-donative surface, the above-mentioned reaction will not proceed and no Al deposited.

Figs. 4A - 4D are illustrations for better understanding of the reacion mechanism, and the numbers of H, e and Al shown in Figs. 4A - 4D are not necessarily coincident.

In the case of an Al-Si film, Si atoms are incorporated into Al during the process of the reaction as described above.

As described above, according to the present invention, a low resistivity, dense and flat Al-Si film could be deposited on a substrate.

Also, depending on the kind of the substrate, Al-Si can be formed with excellent selectivity.

## Claims

**1.** A thermal CVD process for forming a deposited Al-Si film comprising the steps of:

(a) providing a substrate having an electron donative surface (A) and optionally an electron non-donative surface in a space of a reaction chamber which is evacuated for formation of the deposited film;

(b) introducing a gas of an alkyl aluminum hydride, a gas containing silicon atoms and hydrogen gas into said space for formation of deposited film; and

(c) maintaining the temperature of said electron donative surface (A) within the range of from the decomposition temperature of said alkyl aluminum hydride to 450 °C to form an aluminum film

containing silicon on said electron donative surface (A).

**2.** The process of claim 1, wherein the gas containing silicon atoms is $Si_2H_6$.

**3.** The process of claim 1, wherein the gas containing silicon atom is $SiH_4$, $S_3H_8$, $Si(CH_3)_4$, $SiCl_4$, $SiH_2Cl_2$ or $SiHCl_3$.

**4.** The process according to any preceding claim, wherein said alkyl aluminum hydride is dimethyl aluminum hydride.

**5.** The process according to any preceding claim, wherein said alkyl aluminum hydride is monomethyl aluminum hydride.

**6.** The process of claim 4 which carried out at a DMAH partial pressure of 1.33 $10^{-2}$ to 1.33 $10^{-1}$ Pa ($10^{-4}$ to $10^{-3}$ Torr) and at a substrate temperature of 200-450 °C.

**7.** The process of any preceding claim, which is carried out at a substrate temperature of 270-350 °C.

**8.** The process according to any preceding claim, wherein said substrate is constituted of a material selected from single monocrystalline silicon, polycrystalline silicon and amorphous silicon.

**9.** The process according to any of claims 1-7, wherein said substrate is a III-V compound semiconductor containing an element belonging to the group III of the periodic table and an element belonging to the group V of the periodic table.

**10.** The process according to any of claims 1-7, wherein said substrate is a II-VI compound semiconductor containing an element belonging to the group II of the periodic table and an element belonging to the group VI of the periodic table.

**11.** The process according to any of claims 1-7, wherein said substrate is a metal.

**12.** The process of claim 11, wherein the substrate contains at least one element selected from tungsten, molybdenum, tantalum, aluminum, titanium and copper.

**13.** The process according to any of claims 1-10, wherein said substrate is a semiconductor.

**14.** The process according to claim 13, wherein said substrate is silicide.

**15.** The process according to any preceding claims, wherein said Al-Si film is monocrystalline.

**16.** A process according to any preceding claim, wherein said electron non-donative surface (B) is formed of an insulating material.

**17.** The process of claim 16, wherein the insulating material is glass, oxidized silicon or silicon nitride.

## Patentansprüche

**1.** Thermisches CVD-Verfahren zur Bildung eines aufgetragenen Al-Si-Films, umfassend die folgenden Schritte:

(a) Bereitstellen eines Substrats mit einer Elektronen-Donatoroberfläche (A) und gegebenenfalls einer Nicht-Elektronen-Donatoroberfläche in einem Raum einer Reaktionskammer, der zur Bildung des aufgetragenen Films evakuiert ist;

(b) Einleiten eines Gases aus einem Alkylaluminiumhydrid, eines Silizium-Atome enthaltenden Gases und von Wasserstoffgas in den Raum zur Bildung des aufgetragenen Films; und

(c) Aufrechterhalten der Temperatur der Elektronen-Donatoroberfläche (A) in dem Bereich von der Zersetzungstemperatur des Alkylaluminiumhydrids bis zu 450 °C unter Bildung eines Silizium enthaltenden Aluminiumfilms auf der Elektronen-Donatoroberfläche (A).

2. Verfahren nach Anspruch 1, bei dem das Silizium-Atome enthaltende Gas $Si_2H_6$ ist.

3. Verfahren nach Anspruch 1, bei dem das Silizium-Atome enthaltende Gas $SiH_4$, $Si_3H_8$, $Si(CH_3)_4$, $SiCl_4$, $SiH_2Cl_2$ oder $SiHCl_3$ ist.

4. Verfahren nach einem der vorhergehenden Ansprüche, bei dem das Alkylaluminiumhydrid Dimethylaluminiumhydrid ist.

5. Verfahren nach einem der vorhergehenden Ansprüche, bei dem das Alkylaluminiumhydrid Monomethylaluminiumhydrid ist.

6. Verfahren nach Anspruch 4, das bei einem DMAH-Partialdruck von $1{,}33 \cdot 10^{-2}$ bis $1{,}33 \cdot 10^{-1}$ Pa ($10^{-4}$ bis $10^{-3}$ Torr) und bei einer Substrattemperatur von 200 bis 450 °C durchgeführt wird.

7. Verfahren nach einem der vorhergehenden Ansprüche, das bei einer Substrattemperatur von 270 bis 350 °C durchgeführt wird.

8. Verfahren nach einem der vorhergehenden Ansprüche, bei dem das Substrat aus einem Material aufgebaut ist, das aus einkristallinem Silizium, polykristallinem Silizium und amorphem Silizium ausgewählt ist.

9. Verfahren nach einem der Ansprüche 1 bis 7, bei dem das Substrat ein III-V-Verbindungshalbleiter ist, der ein Element, das zur Gruppe III des Periodensystems gehört, und ein Element, das zur Gruppe V des Periodensystems gehört, enthält.

10. Verfahren nach einem der Ansprüche 1 bis 7, bei dem das Substrat ein II-VI-Verbindungshalbleiter ist, der ein Element, das zur Gruppe II des Periodensystems gehört, und ein Element, das zur Gruppe VI des Periodensystems gehört, enthält.

11. Verfahren nach einem der Ansprüche 1 bis 7, bei dem das Substrat ein Metall ist.

12. Verfahren nach Anspruch 11, bei dem das Substrat mindestens ein Element, ausgewählt aus Wolfram, Molybdän, Tantal, Aluminium, Titan und Kupfer, enthält.

13. Verfahren nach einem der Ansprüche 1 bis 10, bei dem das Substrat ein Halbleiter ist.

14. Verfahren nach Anspruch 13, bei dem das Substrat Silizid ist.

15. Verfahren nach einem der vorhergehenden Ansprüche, bei dem der Al-Si-Film einkristallin ist.

16. Verfahren nach einem der vorhergehenden Ansprüche, bei dem die Nicht-Elektronen-Donatoroberfläche (B) aus einem isolierenden Material gebildet ist.

17. Verfahren nach Anspruch 16, bei dem das isolierende Material Glas, oxidiertes Silizium oder Siliziumnitrid ist.

## Revendications

1. Procédé thermique de dépôt chimique en phase vapeur (CVD) pour la formation d'un film de Al-Si déposé, comprenant les étapes consistant :
   (a) à prendre un substrat ayant une surface (A) cédant des électrons et facultativement une surface ne cédant pas d'électrons dans un espace d'une chambre de réaction qui est mise sous vide pour la formation du film déposé ;
   (b) à introduire un gaz d'un hydrure d'alkylaluminium, un gaz contenant des atomes de silicium et de l'hydrogène gazeux dans ledit espace de formation d'un film déposé ; et
   (c) à maintenir la température de ladite surface (A) cédant des électrons dans l'intervalle de la température de décomposition dudit hydrure d'alkylaluminium à 450 °C pour former un film d'aluminium contenant du silicium sur ladite surface (A) cédant des électrons.

**2.** Procédé suivant la revendication 1, dans lequel le gaz contenant des atomes de silicium est $Si_2H_6$.

**3.** Procédé suivant la revendication 1, dans lequel le gaz contenant des atomes de silicium est $SiH_4$, $S_3H_8$, $Si(CH_3)_4$, $SiCl_4$, $SiH_2Cl_2$ ou $SiHCl_3$.

**4.** Procédé suivant l'une quelconque des revendications précédentes, dans lequel l'hydrure d'alkylaluminium est l'hydrure de diméthylaluminium.

**5.** Procédé suivant l'une quelconque des revendications précédentes, dans lequel l'hydrure d'alkylaluminium est l'hydrure de monométhylaluminium.

**6.** Procédé suivant la revendication 4, qui est mis en oeuvre sous une pression partielle d'hydrure de diméthylaluminium (DMAH) de 1,33 $10^{-2}$ à 1,33 $10^{-1}$ Pa ($10^{-4}$ à $10^{-3}$ torr) et à une température du substrat de 200 à 450 °C.

**7.** Procédé suivant l'une quelconque des revendications précédentes, qui est mis en oeuvre à une température du substrat de 270 à 350 °C.

**8.** Procédé suivant l'une quelconque des revendications précédentes, dans lequel le substrat est constitué d'une matière choisie entre le silicium monocristallin, le silicium polycristallin et le silicium amorphe.

**9.** Procédé suivant l'une quelconque des revendications 1 à 7, dans lequel le substrat est un semiconducteur consistant en un composé III-V, contenant un élément appartenant au Groupe III du Tableau Périodique et un élément appartenant au Groupe V du Tableau Périodique.

**10.** Procédé suivant l'une quelconque des revendications 1 à 7, dans lequel le substrat est un semiconducteur consistant en un composé II-VI, contenant un élément appartenant au Groupe II du Tableau Périodique et un élément appartenant au Groupe VI du Tableau Périodique.

**11.** Procédé suivant l'une quelconque des revendications 1 à 7, dans lequel le substrat est un métal.

**12.** Procédé suivant la revendication 11, dans lequel le substrat contient au moins un élément choisi entre le tungstène, le molybdène, le tantale, l'aluminium, le titane et le cuivre.

**13.** Procédé suivant l'une quelconque des revendications 1 à 10, dans lequel le substrat est un semiconducteur.

**14.** Procédé suivant la revendication 13, dans lequel le substrat est un siliciure.

**15.** Procédé suivant l'une quelconque des revendications précédentes, dans lequel le film de Al-Si est monocristallin.

**16.** Procédé suivant l'une quelconque des revendications précédentes, dans lequel la surface (B) ne cédant pas d'électrons est formée d'une matière isolante.

**17.** Procédé suivant la revendication 16, dans lequel la matière isolante est le verre, le silicium oxydé ou le nitrure de silicium.

FIG. 1

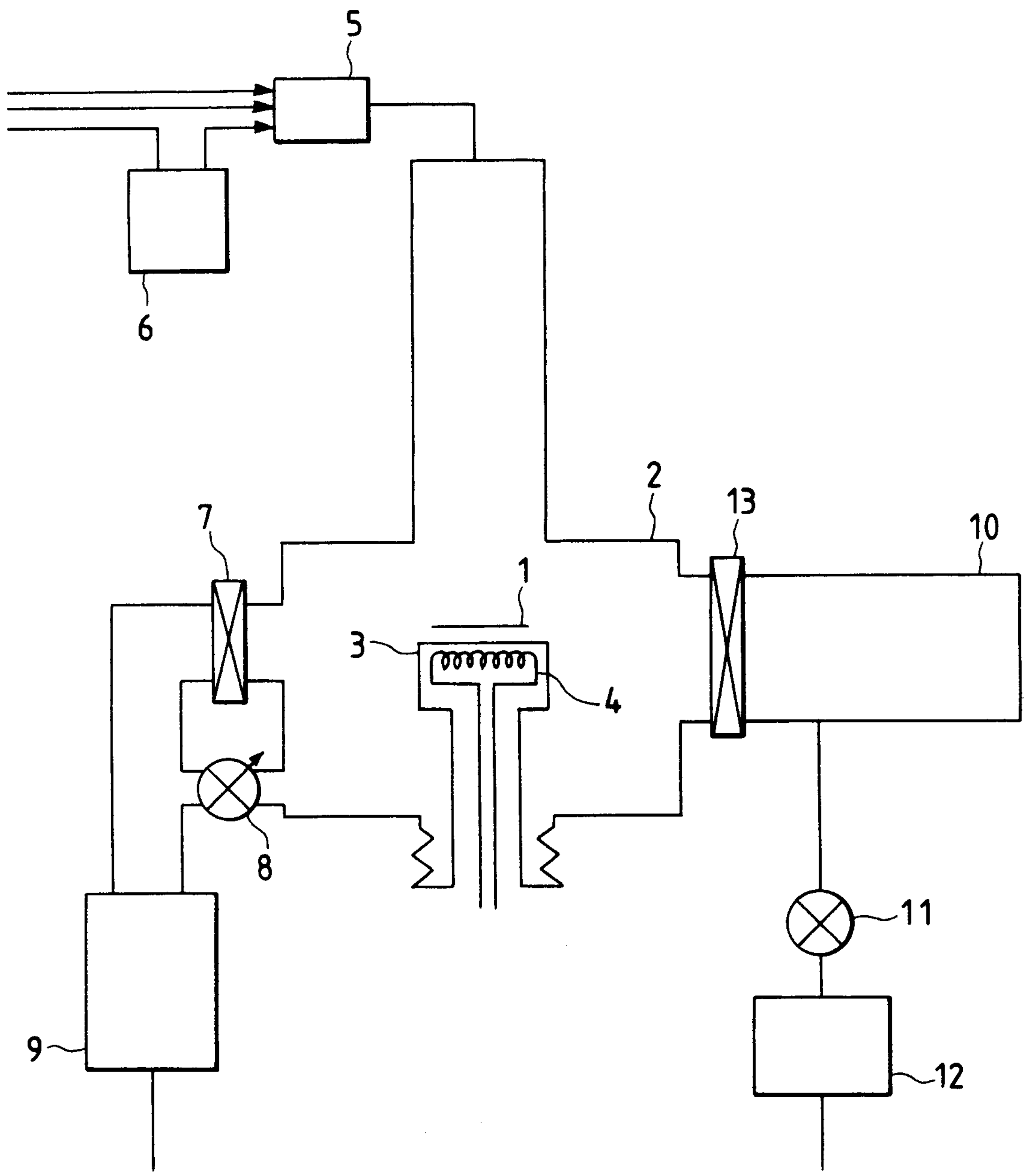

FIG. 2

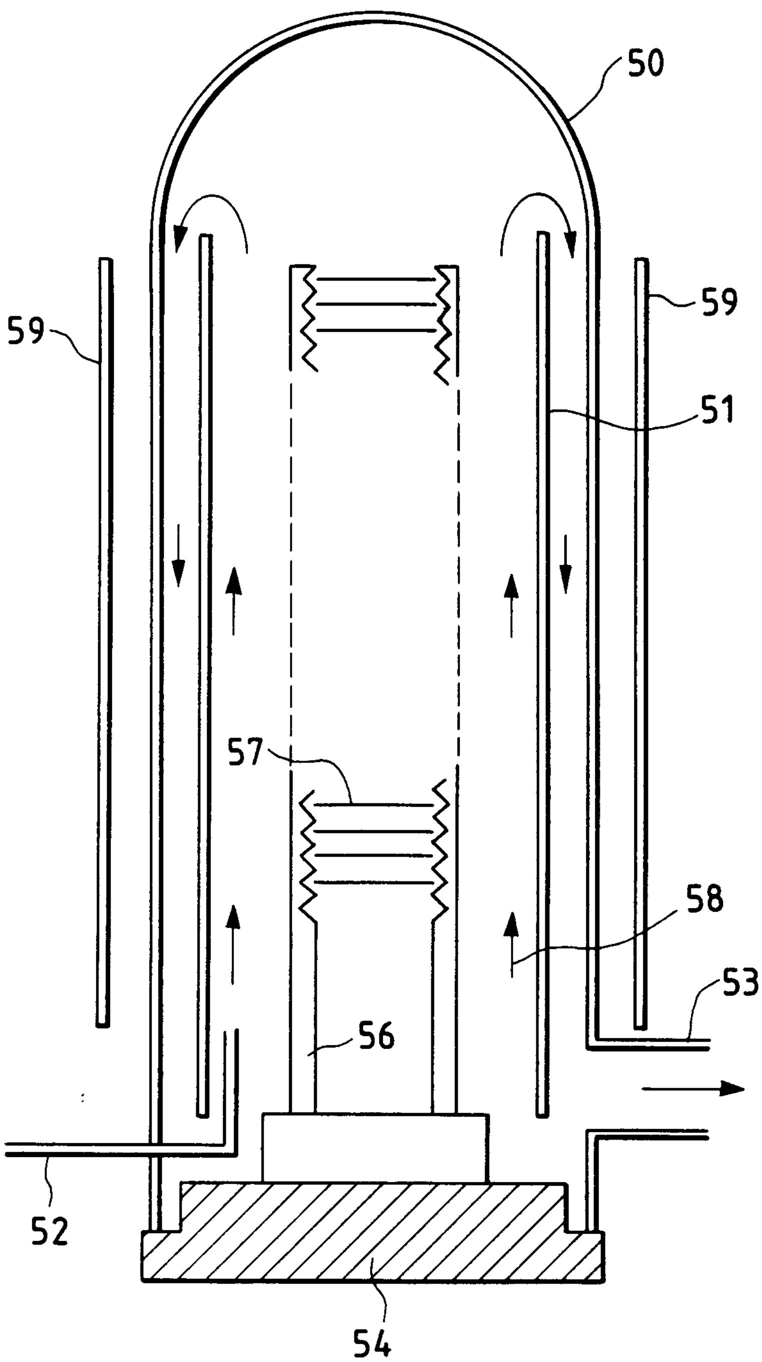

FIG. 3A

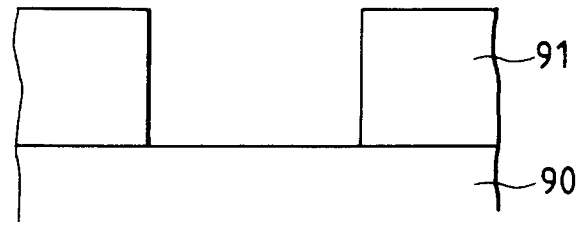


FIG. 3B

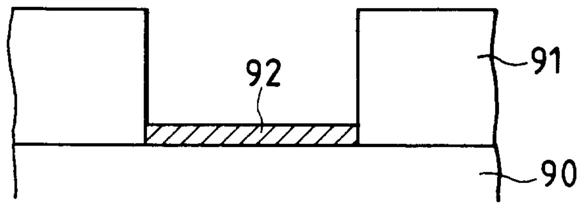


FIG. 3C

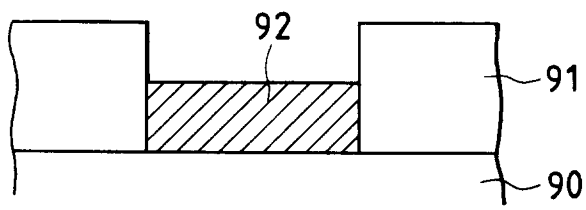


FIG. 3D

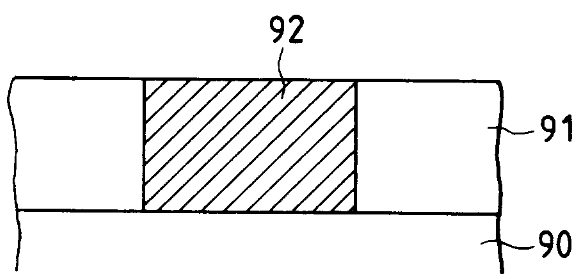


FIG. 3E

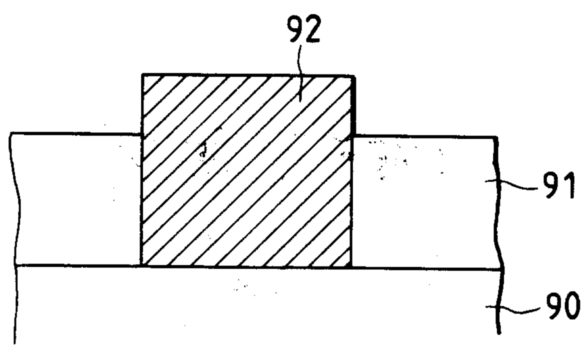

FIG. 4A

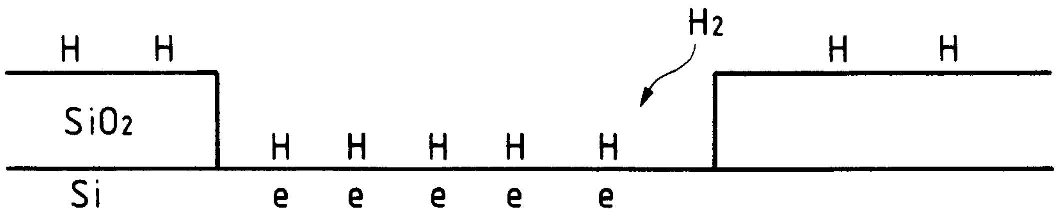

FIG. 4B

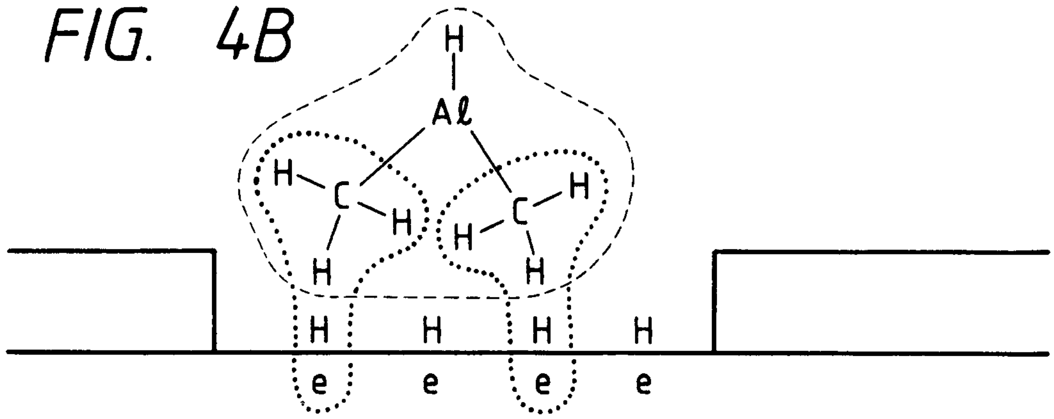

FIG. 4C

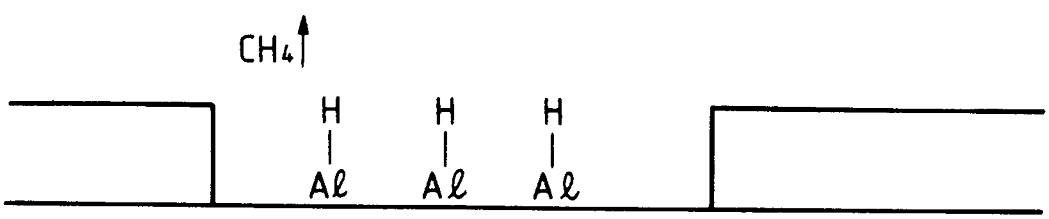

FIG. 4D